# EUROPÄISCHE PATENTSCHRIFT

(11) **EP 1 406 297 B1**
(45) Veröffentlichungstag und Bekanntmachung des Hinweises auf die Patenterteilung: **09.01.2008**
(21) Anmeldenummer: 03090048.4
(22) Anmeldetag: 25.02.2003
(51) Int. Cl.: H01L 23/473

(54) **Mikrostrukturkühler und dessen Verwendung**
Microstructure cooling device and use thereof
Dissipateur de chaleur à microstructures et son utilisation

(30) Priorität: 02.10.2002 DE 10246990
(43) Veröffentlichungstag der Anmeldung: 07.04.2004
(73) Patentinhaber: ATOTECH Deutschland GmbH, 10553 Berlin (DE)
(72) Erfinder: Meyer, Heinrich, 14109 Berlin (DE); Crämer, Konrad, 14167 Berlin (DE); Kurtz, Olaf, 10627 Berlin (DE); Prechtl, Peter, 81241 München (DE); Theisen, Sven, 82319 Starnberg (DE); Höhn, Markus, 82041 Oberhaching (DE); Herber, Ralph, Dr., 12107 Berlin (DE)
(74) Vertreter: Bressel, Burkhard

(56) Entgegenhaltungen:
- EP-A- 1 113 496
- DE-A- 19 853 750
- FR-A- 2 748 800
- US-A- 5 423 376
- US-A- 5 727 618

## Beschreibung

Die Erfindung betrifft Kühler, die durch Mikrostrukturen gekennzeichnet sind (Mikrostrukturkühler) und die zur Kühlung von Gegenständen durch wärmeleitenden Kontakt verwendet werden. Insbesondere betrifft die Erfindung eine Verwendung der Mikrostrukturkühler zur Kühlung elektronischer Bauelemente, insbesondere von Prozessoren, z.B. von Central Processing Units (CPU) und von Leistungselektronik-Bauelementen. Der erfindungsgemäße mikrostrukturierte Kühler ist in Konstruktion/Design, Struktur und Fügeverfahren massenproduktionstauglich auf das Herstellverfahren abgestimmt und ermöglicht so eine kostengünstige Herstellung der Mikrostrukturkühler in hohen Stückzahlen.

Die kontinuierliche Steigerung der Leistung elektronischer Bauteile, beispielsweise die Steigerung von Taktfrequenzen bei Mikroprozessoren, geht mit zunehmender Wärmeentwicklung dieser Bauteile einher. Die Miniaturisierung der Bauteile verstärkt diese Entwicklung noch zusätzlich. Thermische Probleme nehmen zu, obwohl Maßnahmen ergriffen werden, um die Verlustleistung der Prozessoren zu mindern. Auch die zunehmende Packungsdichte der Einzelkomponenten innerhalb des Gesamtsystems, z.B. eines Servers, führt dazu, dass auf immer kleinerem Raum immer mehr Wärme abgeführt werden muss. Leistung und Lebensdauer der elektronischen Bauteile hängen aber von den Maximalwerten der Betriebstemperatur und deren Schwankungsbereich ab. Hieraus erwächst die Notwendigkeit, sehr leistungsfähige, kompakte Kühlsysteme zu verwenden, um eine effiziente lokale Wärmeabfuhr zu sichern.

Derzeit setzt ein moderner Prozessor beispielsweise 70 Watt auf einer Grundfläche von 1cm² in Form von Wärme frei; das ist wesentlich mehr Wärme als eine Heizplatte eines Küchenherds erzeugt (∼10 Watt/cm²). Um diese Wärmemenge:abzuführen, werden als wichtigste Kühlsysteme Kühlkörper, Lüfter, kombiniert mit Kühlkörpern, Heat Pipes, Peltieraggregate und Flüssigkeitskühlungen eingesetzt. Es ist zu erwarten, dass die abzuführenden Wärmemengen in der Zukunft noch steigen werden.

Die gegenwärtig am häufigsten verwendete Kühltechnik für elektronische Bauelemente ist die Kühlung mit Umgebungsluft. Für viele Anwendungen hat sie sich als einfach und kostengünstig erwiesen. Bei höheren Kühlleistungen ist dieses Prinzip äußerst unwirtschaftlich, da dann Klimaanlagen mit entsprechend hohen Leistungen nötig sind, was nicht nur die Investitions- und Betriebskosten in die Höhe treibt, sondern auch unter energie- und umweltpolitischen Aspekten problematisch ist.

Mit den neuen Generationen von Prozessoren, die eine sehr hohe Wärmeleistung entwickeln, stößt die Luftkühlung auch leistungsmäßig an ihre Grenzen. Zwar kann die Wärmeabfuhr durch Steigerung der Lüfterleistung meist noch gesichert werden, wodurch jedoch die Laufgeräuschentwicklung ansteigt. 55 dB sind heute für Anwendungen im Geschäftsbereich und in Haushalten schon nicht mehr akzeptabel.

Die hohe Packungsdichte von Prozessoren und anderen Wärme erzeugenden Komponenten auf engstem Raum, wie beispielsweise in Servern, erschwert den Luftaustausch in den Gehäusen, erhöht das Problem des Wärmestaus und führt damit zur Erhöhung der Gefahr von Überhitzung und Ausfall elektronischer Komponenten. Die Zuverlässigkeit und die Wartungsarmut sind aber vor allem bei der Anwendung in Servern und Workstations entscheidende Leistungskriterien. Überdies kann es zwischen den CPUs, die im Gigahertzbereich betrieben werden, und dem elektrisch betriebenen Lüfter zu elektromagnetschen Wechselwirkungen kommen, die zu Funktionsstörungen der CPU führen.

Um die Kühlwirkung der Luft zu verbessern, werden Bauelemente mit hoher Wärmeentwicklung meist mit Kühlkörpern versehen. Die Kühlkörper bestehen meist aus einem massiven metallischen Kern oder einer metallischen Platte aus Kupfer oder Aluminium, deren Oberseite sich beispielsweise durch eine gliedrige Struktur zur Flächenvergrößerung und damit zur besseren Wärmeverteilung auszeichnet. Auf die Kühlkörper kann ein Lüfter montiert werden. Die Auslegung solcher Kühlsysteme ist wegen des Platzbedarfs und des Gewichts geometrisch nur begrenzt anpassungsfähig und überdies mit starken Laufgeräuschen, typischerweise zwischen 40 und 60 dB, verbunden (c't, 18, S.122, 2002). In dem gleichen Artikel wird auf ein relativ kleines ΔT zwischen 30 und 40 °C, gemessen zwischen der maximalen CPU-Temperatur und der maximalen PC-Innentemperatur, bei den getesteten Luftkühlern hingewiesen. Aus diesen Gründen ist man daher häufig gezwungen, bei Verwendung von Luftkühlem Kompromisse einzugehen, die mit technischen und wirtschaftlichen Nachteilen verbunden sind.

Heat Pipes sind seit den 60er Jahren kommerziell erhältlich und werden seit einigen Jahren zunehmend als high-end-Kühlsysteme für die elektronische Industrie eingesetzt. Heat Pipes werden durch ein passives, geschlossenes Kühlsystem gebildet, mit dem durch einen Zwei-Phasen-Mechanismus des Kühlmittels eine sehr gute Wärmeübertragung erreicht wird. Die Wärmeaufnahme vom zu kühlenden elektronischen Bauelement führt zur Verdampfung des Kühlmittels in dem geschlossenen System, das sich durch den sogenannten adiabatischen Zwischenraum in den Kondensationsteil der Heat Pipe bewegt. Dort wird die Wärme durch eine zusätzliche Wärmesenke abgeführt. Dabei bildet sich das Kondensat, das dann über eine mesoporöse Randschicht in den Verdampfungsbereich zurück geführt wird. Die Einstellung dieses Zwei-Phasen-Mechanismus' ist nur in einem sehr begrenzten Temperaturbereich mit bestimmten Kühlmedien möglich und limitiert die Einsatzmöglichkeiten der Heat Pipes erheblich. Überdies ist die Kühlleistung dieser Systeme beispielsweise im Vergleich zu Wasserkühlungen gering.

Peltier-Kühlaggregate werden beispielsweise in der Elektronik, in der Klimatechnik sowie in der Medizin- und Labortechnik als Wärmepumpen eingesetzt. Sie sind sehr kompakt, aber sehr teuer und eignen sich in der Regel nicht, wenn erhebliche Wärmemengen kostengünstig lokal beseitigt werden sollen. Die Peltier-Kühlaggregate benötigen zudem Wärmesenken zur Gegenkühlung sowie ein elektrisches Netzteil für die Stromversorgung. Der Energieverbrauch wird um den Betrag der zusätzlich benötigten Energie erhöht. Aus diesem Grunde ist der Strombedarf dieser Aggregate im Verhältnis zur Kühlleistung hoch, so dass deren Einsatz für Massenanwendungen unwirtschaftlich ist.

Wasserkühlsysteme aus metallischen oder keramischen Werkstoffen zeigen im direkten Vergleich zu den o.g. Kühlsystemen die höchste Kühlleistung. Dies ist vor allem auf die hohe Wärmekapazität des Wassers und dessen geringe Viskosität zurückzuführen. So werden seit kurzer Zeit Wasserkühler aus Kupfer, Aluminium und Keramik zur Kühlung von Mikroprozessoren auf dem Markt angeboten. Alle diese Produkte sind heute durch hohe Herstellungskosten einer nicht industriellen Kleinserienfertigung gekennzeichnet. Typische Leistungsdaten und Preise der am Markt angebotenen konventionellen Kühler liegen bestenfalls bei einem Temperaturunterschied ΔT zwischen CPU und dem Kühlwassereinlass (T_{CPU}-T_{kühlwassereinlass}) von 12,5 bis 16 °C unter Volllast bei einer Kühlmedium-Durchflussmenge von 3 l/min, z. B. mit einer AMD 2000+, bei einer Durchflussmenge von 1 - 20 l/min, bei einem Druckverlust von 25 bis max. 250 mbar, bei einem Gewicht von ca. 200 - 400 g, bei **Bauteil-Volumina** zwischen 30 und 100 cm³ und derzeitigen Preisen von 50 - 100 €. Ausgelegt sind die Kühler für die Verwendung von Aquarienpumpen mit einer typischen Pumpleistung von 1-3 l/min. bei einem Druckverlust von 130-140 mbar.

Die Firma Innovatek bietet derzeit Wasserkühler an, wobei das Modell innovaCOOL rev3.0 als gegenwärtig leistungsfähigster im Markt erhältlicher Kühler zu einem Preis von - 80€ beurteilt wird (z. B. Chip, Oktober 2002, S.48).

Die Leistungsdaten sind am Beispiel einer Gegenüberstellung des innovacool rev3.0 und einem optimierten mikrostrukturierten Kühler als Beispiel in der Designvariante B (siehe Anhang) in der folgenden Tabelle zusammengefasst:

| | **innovaCOOL rev3.0** | **Erfindungsgemäßer Kühler** |
|---|---|---|
| | | **(Bsp. Design B)** |
| Gewicht | 312g | 80 g |
| Volumen | 80 cm³ | 8 cm³ |
| ΔT | 12,5 K | 9,4 K |
| Durchflussmenge | 2,8 l/min. | 1,5 l/min. |
| Kühlmedium | Wssser/Glykol 95%/5% | |

Die vergleichenden Tests wurden unter identischen Bedingungen zur Kühlung einer AMD 2000+ CPU unter Volllast gemessen.

Bei Kühlern für Leistungshalbleiter gibt es erste Ansätze, Kanalquerschnitte von weniger als 1 mm² zu verwenden, wie sie auch bei Mikrowärmeaustauschern bzw. Mikroreaktoren zu finden sind.

Ein Wasserkühlsystem für Leistungshalbleiterschaltungen ist beispielsweise in "Innovative Chip-Level-Cooling", J. Schulz-Harder, in PCIM Europe, März 2002, Seiten 27-42 beschrieben. Der Kühler ist aus Kupferlagen hergestellt und durch ein Lötverfahren mittels eutektischer Schmelze mit dem Keramiklagen aufweisenden Halbleiterträger verbunden. Zur Herstellung des Kühlers werden die Kühlkanäle in den Kupferlagen wie bei der Leiterplattenherstellung durch Ätzen erzeugt. Es wird ein flüssigkeitsdurchströmter Kühlkörper gebildet, der in der inneren Struktur 8 bis 10 Kupferlagen mit einer hexagonalen Grundstruktur (Dicke der Lagen jeweils 0,3 mm) und Säulen mit einem Durchmesser von 1,5 mm aufweist. Es wird angegeben, dass eine Wärmemenge von 400 Watt/cm² abgeführt werden kann. Bei einer Durchflussmenge von 5 I Wasser pro Minute entsteht ein Druckverlust von 640 mbar. Aus der Beschreibung geht eindeutig hervor, dass es sich um ein teures Hochleistungsbauteil handelt.

Ferner ist in WO 98/41076 A2 eine Vorrichtung zum Kühlen von elektronischen Bauelementen beschrieben, in der die Leistung durch eine Wärmesenke gegenüber bekannten Kühlern erheblich gesteigert und der Wärmeübergangskoeffizient und damit der thermische Gesamtleitwert wesentlich verbessert werden sollen. In dem Dokument wird hierzu angegeben, dass der größte Druckverlust, den die Kühlflüssigkeit beim Durchgang durch die mikrostrukturierte Wärmesenke erzeugt, im Bereich der Verteilerstrukturen und der Verbindungskanäle auftrete. Um das Problem zu lösen, wird vorgeschlagen, einen Kühler zu schaffen, der eine Vielzahl von Einzelschichten aufweist und aus wenigstens einer Platte mit zahlreichen Mikrokanälen und einem Verteilerkanal besteht und der ferner eine Zwischenplatte mit Verbindungskanälen und eine Sammelplatte mit Sammelkanälen aufweist, wobei abgeschlossene Kühlkanäle entstehen, wenn diese Platten zusammen mit einer Deckel- und einer Grundplatte versehen worden sind. Das Kühlmittel in den Kühlkanälen wird durch eine Zulauföffnung in die Mikrostrukturwärmesenke eingeleitet und durch eine Ablauföffnung aus dieser wieder hinausgeleitet. Die Zwischenplatte für das Kühlmittel bildet eine stufenförmige und/oder abgeschrägte Übergangsstruktur, durch die Querschnittsflächen der Zu- und/oder Ablauföffnung, die jeweils durch einen senkrechten Schnitt zur Oberfläche durch alle Einzelschichten dargestellt sind, in die Querschnittsfläche der Mikrokanäle sukzessive überführt werden. Beispielhaft wird ein Kühler mit einem Strömungsquerschnitt der Kühlkanäle von 0,3 mm x 10 mm genannt. In diesem Kühler werden beispielsweise ein Wärmeübergangskoeffizient von 8,5 Watt/cm²·K und ein Druckverlust von 0,5 bar bei einem Durchfluss von 500 ml/min erreicht. Mit diesen Leistungsdaten erreicht dieser relativ aufwendige Kühler nur etwa 10% der Kühlleistung, die für eine durchschnittliche CPU gefordert wird.

Ein anderes Kühlerdesign wird in DE 198 53 750 A1 vorgeschlagen: Der Kühler weist eine Kühlerfläche für elektrische oder elektronische Komponenten auf und besteht zumindest teilweise aus mehreren stapelartig übereinander angeordneten und flächig miteinander verbundenen Kühlerlagen, von denen zumindest einige Lagen derart strukturiert sind, dass sie im Inneren des Kühlers zwischen einem Einlass und einem Auslass für ein Kühlmedium eine zweidimensionale Kühlerstruktur mit sich zumindest in zwei Raumachsen verzweigenden Strömungswegen für das Kühlmedium bilden. Wenigstens ein Teil der die Kühlerstruktur bildenden Kühlerlagen ist derart strukturiert, dass in dieser Kühlerstruktur jeweils das Verhältnis oder der Gradient des spezifischen Strömungswiderstandes zwischen Bereichen, die näher zur Kühlerfläche liegen, und Bereichen, die von dieser Kühlerfläche weiter beabstandet sind, vom Einlass zum Auslass hin zunimmt. Der Kühler weist einen geöffneten Weg auf, der sich durch den Stapel verlängert, so dass die Strömung des Kühlmediums nicht auf die einzelnen Kühlerlagen beschränkt ist.

Im Gegensatz zu Mikroreaktoren und Mikrowärmeaustauschern, die bereits in Forschungs- und Entwicklungsprojekten und auch in ersten industriellen Prozessen eingesetzt werden, ist das Problem der Auslegung von elektronischen Kühlern noch völlig offen, da sich das "Wärmemanagement" in einem Mikroreaktor oder Mikrowärmeaustauscher und einem Kühler, der Wärme von einer Fläche abführen muss, grundsätzlich unterscheidet.

In einem Reaktor muss Wärme, die in einem strömenden Medium; d.h. *innerhalb des Reaktors* entsteht, möglichst schnell abgeführt bzw. ausgetauscht werden, um dem Ideal der isothermen Prozessführung möglichst nahe zu kommen. Aus diesem Grunde versucht man innerhalb der verfahrenstechnischen Grenzen einer Reaktion, die Querschnitte der Kanäle und die Wandstärke zwischen den Kanälen möglichst gering zu halten. Natürlich muss auch ein Reaktor bezüglich der Auslegung, z.B. bezüglich Strömungswiderstand, Durchsatz etc., optimiert werden; aber das zugrundeliegende Wärmemanagement-Prinzip ist vergleichsweise einfach.

Exemplarisch ist berichtet worden, dass Mikrostrukturbauteile aus einzelnen dünnen metallischen Blechen (Folien) hergestellt werden können, die sich durch eine feine Struktur, die Mikrostruktur, auszeichnen (siehe beispielsweise US-A-4,516,632). In einem Kühler für elektronische Bauteile hingegen muss die Wärme von einer starken, lokalen äußeren Wärmequelle abgeleitet werden.

Bei näherer Betrachtung erweist sich diese Aufgabe, d.h. Wärmeableitung von einer lokal stark erhitzten Oberfläche, als ein sehr komplexes Problem. Die Schwierigkeit besteht darin, dass die eigentliche Wärmequelle außerhalb des Kühlers liegt, d.h. es müssen in weit größerem Umfang die Wärmewiderstände innerhalb der dreidimensionalen Struktur des mit Flüssigkeit durchströmten Kühlkörpers berücksichtigt werden.

Die Problemlösung wird nun durch weitere, spezifische Anforderungen in der Elektronik (beispielsweise bei der Kühlung von CPU-Bauelementen) noch dadurch erschwert, dass die Wärme bei minimalem Kühlwasserbedarf und minimalem Druckverlust im Kühler abgeführt werden muss.

Es hat sich nämlich herausgestellt, dass eine Erhöhung der Kühlleistung durch Verwendung immer feinerer Strukturen, d.h. geringerer Kanalquerschnitte, nur begrenzt möglich ist, da dann der Strömungswiderstand zu stark ansteigt.

Dieser Effekt wird immer dann zu einem Problem, wenn eine große Wärmemenge über eine kleine Fläche abgeführt werden soll, ohne dass der Strömungswiderstand zu stark ansteigt: In diesem Falle kann also die Kühlleistung nicht einfach dadurch erhöht werden, dass die Strömungsgeschwindigkeit des Kühlmittels durch höhere Druckdifferenz gesteigert wird, wie es nach dem Stand der Technik üblich ist.

Für eine Anwendung in PCs, Servern und Workstations werden typischerweise Niederdruckpumpen verwendet, die z.B. einen Druck von bis zu ca. 250 mbar erzeugen. Leistungsstarke Kühlmittel-Pumpsysteme für übliche Mikroreaktoren, die unter erhöhtem Vordruck, beispielsweise 5 bar und mehr, arbeiten, sind aus Kostengründen hier nicht akzeptabel.

Eine weitere Forderung ist, dass der Kühler eine an die Form des elektronischen Bauelements angepasste Form aufweist, d.h. die Fläche des Kühlers und die Montagefläche am Bauelement sollen gleich groß sein.

Schließlich muss zum Zwecke der Massenanwendung gewährleistet sein, dass die Herstellkosten für den Flüssigkeitskühler und das Kühlsystem nicht wesentlich höher sind als für die Luftkühlung.

Zusammenfassend lässt sich feststellen, dass nach dem Stand der Technik diese Forderungen nicht oder nur teilweise erfüllt werden. Das betrifft insbesondere die Forderung nach kostengünstiger Massenfertigung für Mikrostrukturkomponenten und die Reduzierung der hohen Strömungswiderstände dieser Bauteile. Außerdem gibt es keine Regeln zur Konstruktion, Auslegung oder zum Design von Mikrostrukturkühlem.

Aufgabe der vorliegenden Erfindung ist es daher,
1. erstmals grundlegende Regeln und Merkmale, d.h. konkrete geometrische Daten zur optimalen Auslegung und Konstruktion von mikrostrukturierten Kühlkörpern für flächenförmige lokale Wärmequellen anzugeben und
2. die speziellen, zusätzlichen Probleme, die mit der Kühlung von Mikroprozessoren (CPUs) und anderen heißen Bauteilen elektronischer Rechner verbunden sind, zu lösen; insbesondere sind die bisher ungelösten Fragen des Strömungswiderstandes bzw. Druckverlustes in Mikrohochleistungskühlern zu lösen; darüber hinaus soll die Auslegung des Kühlers weitgehend skalierbar, d.h. auf einfache Weise an die jeweiligen Anforderungen anpassbar sein; so sollte sich die Leistungsaufnahme von 70 Watt/cm² auf 500 Watt/cm² steigern und der Kühler in seiner Auslegung, Größe, seinem Volumen, der Montage, etc. an das Gesamtsystem in optimaler Weise anpassen lassen.

Die vorstehenden Aufgaben werden durch den Mikrostrukturkühier nach Anspruch 1 und durch die Verwendung des Mikrostrukturkühlers nach Anspruch 18 gelöst. Bevorzugte Ausführungsformen der Erfindung sind in den Unteransprüchen angegeben.

Der Kühler, insbesondere für ein elektronisches Bauteil, umfasst einen Stapel von mindestens zwei Metallfolien (Metallblechen) und einer über eine thermische Kontaktfläche in thermischen Kontakt mit dem zu kühlenden Gegenstand bringbare Grundplatte. Die Metallfolien und die Grundplatte sind stoffschlüssig durch geeignete Fügetechniken, vorzugsweise Löten, miteinander verbunden. In den Metallfolien sind Kanäle vorhanden, in denen das Kühlmittel strömt, über das die Wärme abgeführt wird.

Die Kanäle in den Metallfolien weisen eine Breite im Bereich von 100 bis 2.000 µm, vorzugsweise im Bereich von 200 bis 500 µm, auf. Es konnte experimentell nachgewiesen werden, dass die Leistungsfähigkeit unter Beibehaltung aller übrigen Parameter ab einer Kanalbreite von 800 µm und mehr stark abnimmt und für Hochleistungsanwendungen nicht mehr vorteilhaft ist. Die Kanaltiefe liegt im Bereich von 25 bis 1.000 µm, vorzugsweise im Bereich von 50 bis 400 µm. Mindestens eine der beiden Geometriegrößen, Kanalbreite und Kanaltiefe, soll vorzugsweise im Mikrometerbereich liegen, und der hydraulische Durchmesser: 4·A/U; A = Querschnittsfläche, U = Umfang (definiert nach: Technische Strömungslehre, Kamprath-Reihe, Vogel Verlag, W. Bohl, 11. Auflage, Seite 131; Incropera, Frank P. und Dewitt, David P., Fundamentals of Heat and Mass Transfer, 4th Edition, John Wiley & Sons, NY, 1996, Seite 449), sollte bevorzugt 200 - 500 µm betragen. Der mittlere Abstand der Kanäle in einer Metallfolie liegt im Bereich von 50 bis 1.000 µm, vorzugsweise im Bereich von 150 bis 300 µm. Falls der Querschnitt der Kanäle außerdem rechteckig oder nahezu rechteckig ist, so dass zwischen den Kanälen ein Steg in der Metallfolie gebildet wird, wird dieser Abstand als "Stegbreite" bezeichnet. Ferner liegt die Restfoliendicke am Boden der Kanäle im Bereich von 50 bis 300 µm, vorzugsweise im Bereich von 80 bis 120 µm. Die Grundplatte des Kühlers weist eine Dicke im Bereich von 200 bis 2.000 µm, vorzugsweise im Bereich von 500 bis 1.500 µm, auf. Für alle angegebenen Parameter gilt, dass die Parameter diese Anforderungen insbesondere bei geforderten sehr hohen Leistungsdichten im besonderen Maße erfüllen, wenn sie innerhalb der bevorzugten Bereiche liegen. Ferner gelten die angegebenen Bereiche für die Parameterfelder insbesondere bei Verwendung von Cu als Grundmaterial.

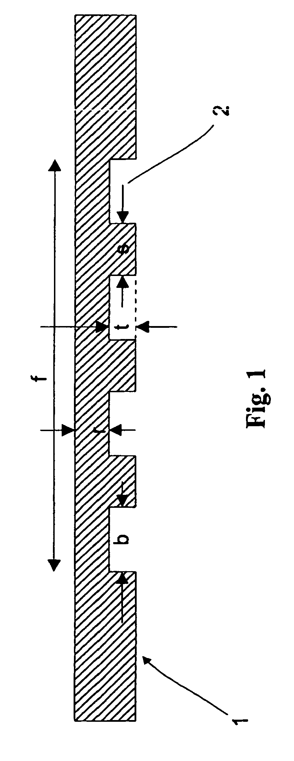

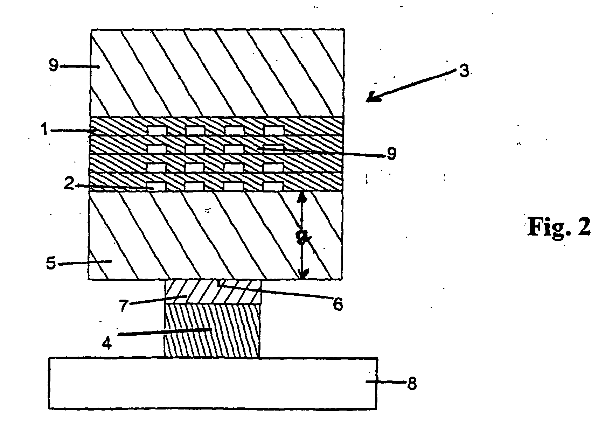

Die Definition der geometrischen Parameter: Kanalbreite, Kanaltiefe, Abstand der Kanäle (Stegbreite), Restfoliendicke und Dicke der Grundplatte ist in Fig. 1,2 dargestellt .

Die unteren Bereichsgrenzen der Kanalbreite, der Kanaltiefe sowie des Kanalabstandes (der Stegbreite) sind im wesentlichen durch die derzeitigen Anforderungen an den Fertigungsprozess gegeben: Bei Einstellung sehr kleiner Werte für diese geometrischen Parameter wird die Herstellung des Kühlers in einer Massenfertigung schwierig, da die notwendigen Toleranzen dann nicht mehr sicher eingehalten werden können. Die Möglichkeiten der Fertigung hängen jedoch von der angewendeten Technologie ab, so dass die unteren Bereichsgrenzen auch noch kleinere Werte annehmen können, wenn die Fertigungstechnik verfeinert wird.

Durch die Verwendung von Mikrostrukturierungsverfahren können sehr viel feinere Kanalstrukturen erzeugt werden als mit konventioneller Technologie. Unter Mikrostrukturtechnik wird im erfindungsgemäßen Sinne ein Herstellverfahren verstanden, bei dem hochaufgelöste Strukturen im Mikrometerbereich gebildet werden, wie sie in der Leiterplattentechnologie erzeugt werden können: Solche Verfahren beinhalten die Erzeugung von Strukturbildern hoher Auflösung, wie beispielsweise photo-lithographische Prozessschritte. Beispielsweise können Kanäle je nach den verwendeten Masken durch Trockenätzverfahren oder durch nasschemische Tiefenätztechnik erzeugt werden. Auch mechanische Mikrofertigung (z. B. Mikrofräsen, Mikroprägen, Umformtechniken o.ä.) ist möglich, wobei leiterplatten-analoge Verfahren bevorzugt werden.

Indem die Kanalbreite, die Kanaltiefe, der Kanalabstand (Stegbreite), die Restfoliendicke und die Grundplattendicke innerhalb der angegebenen Bereiche gewählt werden, gelingt es, den Druckverlust durch das erfindungsgemäße Design der Mikrostruktur wirksam zu vermindern sowie eine möglichst geringe Temperaturdifferenz zwischen dem zu kühlenden Gegenstand und dem Kühlmittel bei vorgegebener Kühlleistung (Wärmeübertragungsleistung) zu erreichen. Eine möglichst geringe Temperaturdifferenz ist selbst dann erreichbar, wenn die Kühlleistung groß ist. Durch Optimierung hinsichtlich des Druckverlustes im Kühler wird ermöglicht, dass Pumpen für die Förderung des Kühlmittels eingesetzt werden können, die weniger verschleißen und somit eine größere Lebensdauer erreichen. Außerdem wird nur eine geringe Pumpleistung für die Zirkulation des Kühlmittels benötigt, so dass die Kosten für den Betrieb des Kühlkreislaufes sowie die Kosten für die Investition des gesamten Kühlsystems (Kühler einschließlich Gegenkühler, Flüssigkeitsleitungen, Pumpe, Stromversorgung für die Pumpe) minimiert werden können. Dadurch wird auch erreicht, dass der Kühler mit einer kostengünstigen industriellen Massenfertigung produziert und dass ein großes Leistungsspektrum der Kühlleistung abgedeckt werden kann.

Die erfindungsgemäßen Bauteil-Abmessungen lassen sich mit konventionellen industriellen Fertigungsmethoden der heutigen Kühlsysteme grundsätzlich nicht realisieren.

Bei erfindungsgemäßer Anwendung der Mikrostrukturtechnik zur Herstellung des Kühlers werden folgende Eigenschaften erreicht:
1. sehr hohe; zuverlässige absolute Dichtigkeit (Vakuumdichtigkeit bis 10⁻⁹ mbar·l/s) der Bauteile zur Umgebung, aber auch zwischen den Mikrokanälen, zur Optimierung des Wärmetransportes durch vollständigen, vollmetallischen Verbund;
2. hervorragende Druckbeständigkeit des Kühlers bzw. Festigkeit der Verbindungen zwischen den Metallfolien und den Deck- und Grundplatten;
3. sehr gute, an das Anwendungsgebiet angepasste Korrosionsbeständigkeit durch elektrochemisch aufgebrachte Korrosionsschutzschichten;
4. hohe Temperaturbeständigkeit;
5. von Ablagerungen freie, geometrisch wohl definierte, homogene Kanäle;
6. minimaler Druckverlust für das Kühlmittel im Kühler.

Die Kanalbreite, die Kanaltiefe, der Kanalabstand, die Restfoliendicke und die Grundplattendicke können insbesondere hinsichtlich des Verhältnisses der Kühlleistung zum Volumen des Mikrostrukturkühlers anwendungsbezogen ausgelegt und beispielsweise für eine AMD 2000+ CPU optimiert werden.

Hierbei lassen sich verschiedene Kennzahlen definieren, welche die Leistungsfähigkeit eines Kühlers beschreiben.

Wichtige Einflussfaktoren dabei sind:

| | |
|---|---|
| Leistung der CPU: | [Watt] |
| Leistung / Fläche der CPU: | [Watt/cm²] |
| Förderkennlinie der Pumpe: | Durchfluss als Funktion des Druckes |
| Druckverluste im System: | [mbar] |

Es lassen sich folgende charakteristische Kenngrößen für den Kühler darstellen:

| | |
|---|---|
| Volumen des Kühlers (ohne Anschlüsse): | [cm³] |
| Durchflussmenge des Kühlmittels: | [l/min] |
| Temperaturdifferenz ΔT zwischen CPU und Kühlmitteleinlass: | [K] |
| ΔT = T_{CPU} - T_{Kühlmediumeinlass} [K] | |
| Temperaturdifferenz (bei vorgegebener CPU)/Leistung: | [K/Watt] |
| Kompaktheit (Kühlleistung/Volumen): | [Watt/cm³] |
| Kühlleistung pro Volumen und ΔT: | [Watt/(cm³·K)] |
| Kühlleistung pro Volumen und ΔT und Durchfluss: | [Watt/(cm³·K·l/min)] |

Die verschiedenen Kenngrößen beschreiben hierbei wichtige anwendungsrelevante Eigenschaften wie Größe, Leistungsfähigkeit, Effizienz und Systemanforderungen.

Zur Bestimmung der Kennzahlen werden ermittelte Kenndaten aus einem typischen Computersystem dargestellt. In diesem System werden zwei verschiedene Kühler unter ansonsten identischen Bedingungen (PC, CPU, Schlauchsystem, Pumpe, Radiator, Messprogramm, usw.) vermessen.

Wichtige Einflussfaktoren dabei sind:

| | |
|---|---|
| Leistung der CPU: | ca. 70 Watt |
| Leistung / Fläche der CPU: | 60 Watt/cm² |
| Förderkennlinie der Pumpe: | Eheim Pumpe |
| Druckverluste im System: | 10 - 100 mbar |

### Beispiel: Gegenüberstellung innovacool rev3.0 und erfindungsgemäßer Kühler in Design A:

### Innovacool rev3.0

### Volumen des Kühlers (ohne Anschlüsse):

| | |
|---|---|
| B x L x H (5 x 5 x 3,5) | 87,5 cm³ |
| Durchflussmenge des Kühlmittels: | 2,7 l/min |
| Temperaturdifferenz ΔT zwischen CPU und Kühlmitteleinlass: | 13 K |
| ΔT = T_{CPU} - T_{Kühlmediumeinlass} [K] | |
| Temperaturdifferenz (bei vorgegebener CPU)/Leistung: | 0,186 K/Watt |
| Kompaktheit (KühlleistungNolumen): | 0,8 Watt/cm³ |
| Kühlleistung pro Volumen und ΔT: | 0,062 Watt/(cm³·K) |
| Kühlleistung pro Volumen und ΔT | |
| und Durchfluss: | 0,023 Watt/(cm³·K·l/min) |
| Innere. Oberfläche/Volumen: | ca. 1,13 cm²/cm³ |

### Erfindungsgemäßer Kühler nach Design A:

Der Kühler ist aus einer Grundplatte (Dicke: 1 mm), 8 strukturierten Folien und einer Deckplatte (Dicke: 1 mm) mit angelöteten Anschlussstutzen aufgebaut.

### Geometrie der strukturierten Folien:

| | |
|---|---|
| Kanallänge: | 16 mm |
| Kanalbreite: | 500 µm |
| Stegbreite: | 200 µm |
| Kanaltiefe: | 230 µm |
| Restbodendicke: | 70 µm |
| Anzahl der Kanäle: | 31 Kanäle/Folie (strukturierte Breite: 21,5 mm) |
| Anzahl der Folien: | 8 |

### Volumen des Kühlers (ohne Anschlüsse):

| | |
|---|---|
| B x L x H (4,9 x 4,9 x 0,5 cm³) | 12 cm³ |
| Durchflussmenge des Kühlmittels: | 1,25 l/min |
| Temperaturdifferenz ΔT zwischen CPU und Kühlmitteleinlass: | |
| ΔT = T_{CPU} - T_{Kühlmediumeinlass} [K] | 11 K |
| Temperaturdifferenz (bei vorgegebener CPU)/Leistung: | 0,157 K/Watt |
| Kompaktheit (Kühlleistung/Volumen): | 5,8 Watt/cm³ |
| Kühlleistung pro Volumen und ΔT: | 0,53 Watt/(cm³·K) |
| Kühlleistung pro Volumen und ΔT | |
| und Durchfluss: | 0,42 Watt/(cm³·K·l/min) |
| Innere Oberfläche/Volumen: | 4,8 cm²/cm³ |

| | Innovatec Rev.3 | Erfindungsgemäßer Kühler (Design A) | Unterschied |
|---|---|---|---|
| Temperaturdifferenz (bei vorgegebener CPU)/Leistung [K/W] | 0,186 | 0,157 | Effizienz um 20 % verbessert |
| Kompaktheit [W/cm³] | 0,8 | 5,8 | 7,5 mal kleiner |
| Kühlleistung pro Volumen und ΔT und Durchfluss | 0,023 | 0,42 | Verbesserung um Faktor 20 |

Die Kennzahlen zeigen deutlich, dass der erfindungsgemäße Kühler erhebliche Vorteile in allen Bereichen bietet.

Die Reduzierung der Temperaturdifferenz um ca. 20% bewirkt unmittelbar eine Energieeinsparung in einem Kühlsystem und damit mit den Betriebskosten. Diese Eigenschaft ist besonders relevant, wenn es sich um Großrechner mit vielen CPUs handelt, da hier Wärmeleistungen von einigen kWatt gekühlt werden müssen.

Die Kühlleistung bezogen auf Volumen, ΔT und Durchfluss ist um einen Faktor 20 größer als bei dem besten Marktführer und zeigt, dass mit diesen Kühlern erheblich höhere Packungsdichten (Anzahl der CPUsNolumeneinheit) erzielt werden können. Dabei ist auch zu beachten, dass der Verrohrungsaufwand (Platzbedarf und Kosten für Schläuche und Kupplungen) erheblich reduziert wird und zu einem besseren Handling (dünne statt dicke Schläuche) führt.

Besonders zu beachten hierbei ist, dass diese Kennzahlen für ein Bauteil gelten, dessen Größe im Moment aus montagetechnischen Gründen der Grundfläche des Chip Carriers und nicht der CPU selbst angepasst ist und sich bei der direkten Integration noch weiter steigern lassen und somit die Unterschiede zu bestehenden Technologien weiter vergrößern.

Die Kanalbreite, die Kanaltiefe, der Kanalabstand, die Restfoliendicke und die Grundplattendicke können auch unter folgenden vorgegebenen Betriebsbedingungen hinsichtlich des Druckverlustes und/oder der vorgenannten Temperaturdifferenz anwendungsbezogen ausgelegt und beispielsweise für eine AMD 2000+ CPU optimiert werden:
a. Flächenleistung der CPU bis 70 Watt/cm²,
b. Differenz zwischen den Temperaturen an der thermischen Kontaktfläche und in dem in den Kühler einfließenden Kühlmittel von weniger als 10 K,
c. Durchflussmenge für das Kühlmittel durch den Kühler im Bereich von 0,01 bis 3 l/min,
d. Druckverlust von weniger als 100 mbar.

In einem identischen Gesamtsystem erreicht ein derzeit auf dem Markt erhältlicher Wasserkühler als Substitut bestenfalls ein ΔT (zwischen CPU und Kühlmedium) im Bereich von 12,5 und 16 K bei einer Durchflussmenge von 1 - 3 l/min und einem Druckverlust von 25 - 250 mbar. Unter gleichen Bedingungen benötigt der erfindungsgemäße Kühler ein um mindestens 30 % niedrigeres ΔT zwischen CPU und Kühlmedium, um die gleiche Wärmemenge abzuführen wie die bislang leistungsstärksten auf dem Markt erhältlichen Flüssigkeitskühler. Der erfindungsgemäße Kühler kann auf den Druckverlust der verfügbaren oder bevorzugten Pumpe über Auslegung und Design unter Sicherstellung ausreichender Leistung ausgerichtet und eingestellt werden.

Der erfindungsgemäße mikrostrukturierte Kühler zeigt somit eine wesentlich höhere Leistung bei einem weitaus kleineren ΔT. Dieser Zusammenhang wird für das hohe Maß der Skalierbarkeit hinsichtlich der Leistung des Mikrostrukturkühlers mitausgenutzt. Was das Verhältnis innere Oberfläche / Kühlervolumen betrifft, so liegt dieses Verhältnis beim kommerziellen Referenzkühler bei 1,13 cm²/cm³ und beim erfindungsgemäßen Prototypen bei 4,8 cm²/cm³, wobei beim erfindungsgemäßen Prototypen die Dicke der Deckplatte von derzeit 1 mm und die Dicke der Seitenwände von ca. 17 mm aus-vorübergehenden fertigungstechnischen Gründen z:Zt. noch nicht optimiert wurden. Unter indestriellen Produktionsbedingungen sind folgende Werte zu erwarten:

| | |
|---|---|
| Innere Oberfläche / Kühlervolumen: | ca. 12 - 15 cm²/cm³ |
| Dicke der Seitenwände: | unter 2 mm |

Die vorgenannten Werte für die Betriebsbedingungen können insbesondere unter Verwendung eines Wasser/Alkohol-Gemisches, insbesondere eines Wasser/Ethylenglykol-Gemisches und ganz besonders eines Gemisches von 95 Vol.-% Wasser und 5 Vol.-% Ethylenglykol als Kühlmittel, noch weiter optimiert werden.

Für die optimale Auslegung der Kanalbreite, der Kanaltiefe, des Kanalabstandes, der Restfoliendicke und der Grundplattendicke ist folgendes zu beachten:

Nach den bisherigen Erkenntnissen für die Auslegung von konventionellen Kühlern wird angenommen, dass eine hohe Wärmeübertragung nur dann erreicht werden kann, wenn in den Kühlern eine turbulente Strömung herrscht (große Reynoldszahl), da unter diesen Bedingungen eine bessere Wärmeübertragung zwischen Kühlmittel und Kühlkanalwand erreicht wird als bei Einstellung laminarer Strömungsverhältnisse. Mit dieser Optimierung geht jedoch eine erhebliche Erhöhung des Druckverlustes einher.

Eine ganz wesentliche Steigerung der Wärmeübertragungsleistung um Größenordnungen, bezogen auf das Volumen des Bauteils, konnte durch Anwendung der Mikrostrukturtechnik zur Herstellung von Kühlern und Wärmetauschem erreicht werden. Als Beispiel wird hier auf käufliche Hochleistungs-Mikrowärmeaustauscher des Forschungszentrums Karlsruhe verwiesen. Insbesondere die hohen Kosten der Mikrostrukturfertigung und die z.T. sehr hohen Strömungswiderstände haben die breite Anwendung der Mikrostrukturtechnologie bislang behindert.

Der Grund für die z.T. sehr hohen Strömungswiderstände der bekannten mikrostrukturierten Wärmeaustauscher beruht darauf; dass eine Erhöhung der Wärmeübertragungsleistung in der Regel mit einer Vergrößerung des Kühlers, längeren Kanälen und damit auf Grund des Hagen-Poisseuilleschen Gesetzes zur Erhöhung des Strömungswiderstandes führt, der aber für bestimmte Anwendungen nicht toleriert werden kann.

Erst durch die vorliegende Erfindung, die es ermöglicht, durch Optimierung der Kanalbreite, der Kanaltiefe, des Kanalabstandes, der Restfoliendicke und der Grundplattendicke erstmals eine Optimierung auch hinsichtlich des Druckverlustes im Kühler zu erreichen, wird dieses Problem gelöst, ohne dass dies zu Lasten der Wärmeübertragungsleistung geht.

Durch diese Maßnahmen gelingt es zusätzlich, die Produktionskosten und damit auch die Systemkosten soweit zu senken, dass Mikrostrukturkühler nicht nur technisch überlegen sind, sondern auch wirtschaftlich konkurrenzfähig werden. Das erfindungsgemäße Kanaldesign basiert darauf, dass der Querschnitt der Kanäle nur soweit minimiert wird, dass unter Betriebsbedingungen in den Kanälen eine laminare Strömung erreicht wird. Turbulenzen werden nur dort toleriert oder herbeigeführt, wo die Strömungsquerschnitte hoch, d.h. die Strömungswiderstände gering sind. Auf diese Weise lässt sich der Druckverlust eines Produkts auf einfache Weise an die jeweilige Anwendung anpassen. In der Regel wird so vorgegangen, dass zunächst die Geometrie (Kanalbreite, -tiefe und -abstand) innerhalb der angegebenen Bereiche durch Einstellung des OberflächeNolumen-Verhältnisses der Strömungskanäle grob optimiert wird. Ein niedriges OberflächeNolumen-Verhältnis der Mikrostruktur, z.B. 3000 m²/m³, bedeutet in der Regel einen geringen Strömungswiderstand aber auch eine geringere Wärmeübertragung. Bei sehr hohen Werten, z.B. 10.000 - 30.000 m²/m³ steigt der Strömungswiderstand stark an, so dass ein Optimum vorzugsweise bei mittleren Oberfläche/Volumen-Verhältnissen erreicht wird.

Wie sich herausgestellt hat reicht aber die Optimierung des Strömungswiderstandes und des OberflächenNolumen-Verhältnisses zur Leistungsoptimierung allein nicht aus. Wie bereits erläutert, liegt bei einem erfindungsgemäßen Mikrostrukturkühler die Wärmequelle außerhalb des Bauteils und wird einerseits über die wärmeleitende Metallstrukturund andererseits durch das Kühlmedium abgeführt: Daraus ergibt sich, dass neben der Optimierung der Strömungsverhältnisse auch die räumliche Struktur des Kühlers zu optimieren ist:

Die Aufgabe der Erfindung wird demnach sowohl durch den "Hydrodynamischen Faktor", der für die optimalen Strömungsbedingungen verantwortlich ist, als auch durch den "Strukturfaktor", der durch das Design des Kühlers festgelegt wird, gelöst.

Nachfolgend werden die erfindungsgemäßen Design-Parameter und ihr Einfluss auf die Kühlleistung dargestellt:

Es hat sich herausgestellt, dass es hinsichtlich der vorgenannten Optimierungskriterien Druckverlust und Temperaturdifferenz besonders günstig ist, das Verhältnis der Kanalbreite zum Abstand der Kanäle (Stegbreite) zu optimieren. Ein zu großes Verhältnis führt zu einer Verschlechterung der Wärmeübertragungsleistung. So sollte dieses Verhältnis (Breite/Abstand) vorzugsweise im Bereich 1,5 - 2,5 : 1 liegen. In gleicher Weise wirkt sich auch ein zu großes Verhältnis der Kanalbreite zur Restfoliendicke aus. Das Verhältnis Kanalbreite/Restfoliendicke soll 2 : 1 bis 5 : 1 betragen.

Durch Minimierung der Restfoliendicke wird ferner ein verbesserter Wärmeübergang zwischen den einzelnen Schichten erreicht. Für die Grundplattendicke gilt folgendes: Da die Temperatur des zu kühlenden Gegenstandes in der Regel über die Fläche nicht konstant ist, könnte es zunächst nahe liegen, die Grundplatte eher dick auszulegen, um eine homogene Temperaturverteilung im Kühler zu erreichen. Andererseits wird die Wärmeübertragung wegen des Wärmewiderstandes des verwendeten Metalls für die Grundplatte mit zunehmender Dicke immer schlechter.

Somit ergibt sich ein Wärmeübertragungsmaximum bei der erfindungsgemäßen Grundplattendicke, die je nach der (gewünschten) Temperaturdifferenz bzw. Auslegung einen etwas größeren oder geringeren Wert annehmen kann. In allen derzeit auf dem Markt erhältlichen Wasserkühlern wird die Wärme durch Verwendung möglichst dicker Bodenplatten (z. B. 5 mm) rasch von der Wärmequelle abgeführt und damit ohne Berücksichtigung des genannten Optimums. Der erfindungsgemäße Kühler besitzt die minimal notwendige Restbodendicke für den entsprechenden Leistungsbereich und führt damit die Mikrostruktur mit dem Kühlmedium so dicht wie möglich an die Wärmequelle heran. Eine optimierte, lokale Wärmeabfuhr bei gleichzeitig starker Kostenreduktion durch Materialeinsparung und Massenreduktion wird somit sichergestellt.

Somit gehen die Parameter zur Kanalgeometrie (Kanalbreite, -tiefe, -länge) in den Druckverlust ein, d.h. in den "Hydrodynamischen Faktor", während die Parameter: Kanalabstand sowie Restfoliendicke und Grundplattendicke, den Wärmeübergang der dreidimensionalen Struktur, d.h. den "Strukturfaktor", beeinflussen. Letzterer ist außerdem noch stark von der räumlichen Anordnung der Kanäle und der Strömungsrichtung, d.h. dem Design abhängig, wie an den weiter unten aufgeführten Design-Beispielen gezeigt wird. Es ist überraschend festzustellen, dass die Strömungsrichtung in Beispiel 2 eine ganz erhebliche Rolle spielt. Nur bei Einleitung des Fluids durch den Spalt, kann das Konstruktionsprinzip seine Vorteile ausspielen. Durch das zentrale Einströmen lässt sich durch geeignete Konstruktion im Einlaufbereich eine Verwirbelung/Turbulenz erzeugen, die den Wärmeübergang unmittelbar über der Wärmequelle erhöht, bevor sich die Strömung schließlich vollständig ausbildet. Der hierbei entstehende Druckverlust sowie der Druckverlust, der beim Verteilen und beidseitigen Einströmen in die Kanäle entsteht, wird durch die Verkürzung der Kanäle und die Verdoppelung der Zahl der Kanäle im Vergleich zu Design A kompensiert. Da nach dem Hagen-Poisseuilleschen Gesetz die Geschwindigkeit proportional zu dem Druckverlust (Δp) ist und durch die Verdoppelung der Kanalzahl eine Halbierung der Strömungsgeschwindigkeit erzielt wird, kann hierdurch sowie durch die Halbierung der Kanallänge, Δp um max. 75 % verringert werden. Der Kanal besitzt eine sog. "kritische Länge", ab der sich die laminare Strömung vollständig ausgebildet hat . Im Anfangsbereich lässt sich die Geschwindigkeitsverteilung durch ein nahezu rechteckiges Profil beschreiben. Im letztgenannten Fall ist der Druckverlust nach dem Hagen-Poisseuilleschen Gesetz größer, der Wärmeübergang jedoch höher. Der Umschlagspunkt muss somit mit dem "Einlaufeffekt" so optimiert werden, dass der Druckverlust kontrolliert minimiert bleibt, der Wärmeübergang aber weiter gesteigert wird.

Grundsätzlich ist aber bei jeder Konstruktion auf möglichst-kurze Kanallängen zu achten.

Ab einem "kritischen Δp" als Minimum bricht die Kühlleistung des Bauteils ein. Dieses Minimum kann durch die beschriebene Designvariante gezielt weiter nach unten verschoben werden.

Weiterhin hat es sich als vorteilhaft herausgestellt, dass eine durch die Kanäle beschriebene Wärmeaustauschfläche im Inneren des Kühlers größer ist als die thermische Kontaktfläche auf der Grundplatte. Beispielsweise können die Strömungskanäle im Kühler ein mehr oder weniger dichtes Muster in einer Metallfolie bilden und somit eine Wärmeaustauschfläche definieren, in der die in den Kühler hineinfließende Wärme von dem Kühlmittel aufgenommen wird. Diese Wärmeaustauschfläche soll größer sein als die Fläche an der Grundplatte, über die der zu kühlende Gegenstand mit dem Kühler in direktem thermischem Kontakt steht. Durch diese weitere Optimierungsmaßnahme wird erreicht, dass die Wärme von dem zu kühlenden Gegenstand über die thermische Kontaktfläche möglichst direkt und vollständig zu den Strömungskanälen und damit in die Kühlflüssigkeit geleitet wird und nicht beispielsweise in die Seitenwände des Kühlers.

Ein weitere Einflussgröße ist das Aspektverhältnis der Kanäle, das heißt das Verhältnis von Kanaltiefe zu -breite. Bei gleichem Kanalquerschnitt wirken sich tiefe Kanäle (hohes Aspektverhältnis) eindeutig positiv auf die Wärmeübertragung des Kühlers aus. Das Aspektverhältnis hängt beim erfindungsgemäßen Verfahren von den Grenzen des jeweiligen Ätzprozesses ab, die maximal erreichbaren Werte liegen derzeit bei 1 : 2 bis 1 : 3.

Durch die beschriebene Design-Optimierung kann eine wirkungsvolle Übertragung von Wärme vom zu kühlenden Gegenstand auf den Kühler und in das Kühlmittel erreicht werden, wobei sich der Druckverlust bei erfindungsgemäßer Einstellung des hydrodynamischen Faktors, wie schon erwähnt, in einem vertretbaren Bereich einstellt. Falls erwünscht kann ein Druckverlust von 100 mbar oder weniger bei einer typischen Wärmeübertragungsleistung von etwa 200 Watt/cm² erreicht werden. Typische Kenngrößen für den Kühler sind: Durchflußmenge: 0,01 -3 l/min und Absolutleistung: 0,02 kWatt - 2 kWatt. Die Leistungsdichte soll im Bereich von mindestens 20 Watt/cm² liegen. Temperaturdifferenz CPU/Fluid bis weniger als 10°C.

Zusätzliche Design-Parameter, die den Strukturfaktor beeinflussen und zur Optimierung heranzuziehen sind: Gesamtanzahl der Kanäle, Anzahl der Metallfolien (Kanalebenen), Fläche auf den Folien, Fläche in den Kanälen (Wärmeaustauschfläche), Kanallänge, Materialart, aus dem die Metallfolien, die Grundplatte, eine Deckplatte zum Abschluss des Kühlers, sowie das Fügematerial für die stoffschlüssige Verbindung der Metallfolien untereinander und mit der Grundplatte bestehen, sowie die Wahl des Materials, das zur thermischen Kontaktierung des zu kühlenden Gegenstandes am Kühler dient.

In dem erfindungsgemäßen Kühler sind mindestens zwei Metallfolien mit Strömungskanälen enthalten. Vorzugsweise sind die Kanäle in Kanalebenen organisiert. Anstelle von zwei Metallfolien kann auch eine einzelne Metallfolie sowie zusätzlich eine zur Aufnahme von Strömungskanälen mit Vertiefungen versehene Grundplatte eingesetzt werden. Insofern ist die eine der beiden Metallfolien dann als Grundplatte zu bezeichnen, wenn diese Kanäle aufweist.

Der Mikrostrukturkühler weist vorzugsweise 2 - 10 Ebenen für die Kanäle auf. Das bedeutet im Hinblick auf die vorstehenden Angaben, dass entweder 1 - 9 Metallfolien und zusätzlich eine mit Kanälen versehene Grundplatte oder 2 - 10 Metallfolien und zusätzlich eine Grundplatte ohne Kanäle vorgesehen sind. Für eine Grundplatte, die Kanäle enthält, gilt die Bedingung, dass die Restfoliendicke im Bereich von 50 - 300 µm liegt, nicht Mit der Anzahl der Kanalebenen wird die Wärmeübergangsleistung von dem zu kühlenden Gegenstand zum Kühlmittel gesteigert. Es hat sich jedoch herausgestellt, dass die Wärmeübertragungsleistung nicht mehr oder zumindest nicht mehr in nennenswertem Umfange weiter gesteigert werden kann, wenn mehr als 8 Lagen gleicher Geometrie vorliegen. Durch einfache Variation der Lagenzahl lassen sich unterschiedliche Leistungsbereiche des Bauteils einstellen und die Herstellungskosten zusätzlich gezielt beeinflussen. Da jede Kanalebene die Kosten erhöht, muss das Produkt auf das anwendungsbezogene Preis/Leistungsverhältnis ausgelegt werden. Bei Anwendung des erfindunggemäßen Herstellungsverfahrens lässt sich der Preis bei ausreichender Leistung des Kühlers bei einer Flächen- bzw. Volumenreduktion durch das anwendungsspezifische Design ganz erheblich senken.

Der erfindungsgemäße Mikrostrukturkühler weist zusätzlich zu den Metallfolien und der Grundplatte, die den Stapel zu der thermischen Kontaktfläche für den zu kühlenden Gegenstand hin abschließt, vorzugsweise eine Deckplatte auf. Die Deckplatte selbst kann eine mit Kanälen versehene Metallfolie sein. Es kann sich dabei aber auch um eine unstrukturierte Deckplatte handeln. Zur Herstellung des Mikrostrukturkühlers werden die strukturierten Folien mit einer Deck- und einer Grundplatte versehen und zu einem kompakten Bauteil gefügt. Vorzugsweise können für die Anschlüsse des Ein- und Auslassbereichs mehrere Durchbrüche in die Deckplatte vorzugsweise geätzt, gestanzt oder gelasert werden. Die Deckplatte wird vorzugsweise aus Metall, Kunststoff, Kunststoff/Spritzguss gefertigt.

Zur Zufuhr von Kühlmittel in den Kühler und zur Abfuhr von Kühlmittel aus dem Kühler sind Vorrichtungen zum Anschluss von Schläuchen vorgesehen, beispielsweise angespritzte, integrierte oder angelötete Anschlussstutzen. Hierbei können die Schlauch- oder Rohrverbindungselemente direkt integriert oder variabel anschraubbar, lötbar, einpressbar und/oder klebbar sein. An diese Stutzen werden Flüssigkeitsleitungen zu den Pumpen und/oder externen Gegenkühlem angeschlossen.

Weiterhin werden die Kanäle in den Metallfolien in der Regel parallel zueinander verlaufen. Das bedeutet aber nicht, dass sie immer gerade verlaufen müssen. Auch parallele "Schlangenlinien", kreis- oder "sternförmige" Kanäle, die nicht unbedingt parallel zueinander verlaufen, o.ä. können vorteilhaft sein. Dies ermöglicht, die Kanäle äußerst eng zueinander anzuordnen, so dass eine sehr wirkungsvolle Wärmeübertragung zwischen dem Kühlermaterial (Metallfolien) und dem Kühlmittel erreicht wird. Darüber hinaus sind auch beliebig in dreidimensionaler Anordnung angeordnete Kanäle denkbar, in denen die einzelnen Lagen mit Durchbrüchen verbunden sind.

Weiterhin kann der Mikrostrukturkühler mindestens einen Einlassverteilerraum und mindestens einen Auslassverteilerraum für das Kühlmittel aufweisen.

Design A: Die Verteilerräume können so angeordnet werden, dass sie sich an zueinander gegenüber liegenden Seitenflächen befinden und sich im wesentlichen über die gesamte Breite der jeweiligen Seitenfläche des Kühlers erstrecken.

Die Kanäle sind in dem ersten Kanaldesign einlassseitig mit einem Einlassverteilerraum und auslassseitig mit einem Auslassverteilerraum verbunden. Somit fließt Kühlmittel in einem derartig strukturierten Kühler über einen ersten Anschlussstutzen in den Kühler hinein und gelangt dort zunächst in den Einlassverteilerraum. Da der Einlassverteilerraum in dieser Designvariante alle Strömungskanäle an einer Seite anschneidet, kann das Kühlmittel von dort in die Strömungskanäle fließen. Nachdem das Kühlmittel durch die Kanäle hindurch getreten ist, gelangt es in den Auslassverteilerraum. Von dort fließt das Kühlmittel in externe Kühlleitungen.

In einer zweiten Designvariante, Design B, sind die Metallfolien etwa in der Höhe der thermischen Kontaktfläche durch mindestens eine einlassseitige Verteilerkammer unterbrochen. Beispielsweise kann diese Verteilerkammer die Metallfolien als Spalt teilen, wobei die Metallfolien vorzugsweise senkrecht zu deren Ebene geteilt sind. Die Spaltbreite kann beispielsweise im Bereich von 50 bis 2.000 µm liegen. Die spaltförmige Verteilerkammer kann den Kühler im wesentlichen über den gesamten Querschnitt senkrecht zu den Metallfolien durchsetzen. Falls die thermische Kontaktfläche etwa mittig auf der Grundplatte angeordnet ist, teilt die Verteilerkammer die Metallfolien ebenfalls etwa mittig. Durch diese Anordnung wird erreicht, dass Kühlmittel, das von oben (wenn die Grundplatte unten liegt) in die Verteilerkammer einströmt, auch etwa in dem zentralen Bereich mit der Grundplatte in Kontakt kommt, in dem sich die thermische Kontaktfläche befindet. Dadurch wird gerade in diesem Bereich eine Strömungsform erzeugt; die zu einer erhöhten Wärmeübertragung führt:

Da die Kanäle vorzugsweise in den Ebenen der Metallfolien verlaufen, sind alle Kanäle an deren einem Ende mit der Verteilerkammer verbunden. In einer bevorzugten Ausführungsform sind zwei Gruppen von im wesentlichen zueinander parallel verlaufenden Kanälen vorgesehen. Ferner ist mindestens eine Sammelkammer innerhalb des Kühlers vorgesehen, mit der alle Kanäle an deren anderem Ende verbunden sind. Es können beispielsweise zwei Sammelkammern vorgesehen sein, die wie im Falle der ersten Designvariante A an zueinander gegenüber liegenden Seitenflächen angeordnet sind und sich im wesentlichen über die gesamte Breite der jeweiligen Seitenfläche des Kühlers erstrecken. Die Sammelkammern sind vorzugsweise miteinander verbunden, so dass Kühlmittel von der Verteilerkammer in die angeschnittenen Strömungskanäle und von dort in die miteinander verbundenen Sammelkammern gelangen kann.

Auch im Falle der zweiten Designvariante B sind mindestens ein erster Anschlussstutzen, der mit den Sammelkammern verbunden ist, sowie mindestens ein zweiter Anschlussstutzen vorgesehen, der mit der Verteilerkammer verbunden ist. Das Kühlmittel kann somit aus einer externen Kühlleitung über den ersten Anschlussstutzen in die Verteilerkammer geführt werden und gelangt von dort in die Strömungskanäle. Das Kühlmittel wird dann in die Sammelkammern geführt und von dort über den zweiten Anschlussstutzen wieder heraus in eine externe Kühlleitung.

Zur Herstellung der Mikrostrukturkühler können Leiterplattenproduktionsanaloge Verfahren verwendet werden, bestehend aus den einzelnen Prozessschritten Fotolithografie, Strukturierung (vorzugsweise Ätzen), Metallisierung und Fügen, vorzugsweise Löten (DE 197 08 472 A1). Die Analogie besteht darin, dass eine komplexe dreidimensionale Struktur durch Stapelung und Verbindung von mikrostrukturierten Folien erzeugt wird. Design, Struktur und Lotsysteme der Bauteile werden massenproduktionstauglich auf dieses Verfahren abgestimmt und ermöglichen so eine kostengünstige Herstellung der Mikrostrukturkühler in hohen Stückzahlen, wobei bestehende Anlagen, die meist nicht oder nur unwesentlich verändert:werden müssen, verwendet werden können: Die Vorteile des beschriebenen Herstellverfahrens sind die Verwendung bereits existierender Mikrostrukturierungsprozesse, die Skalierbarkeit für industrielle Massenproduktion und sehr niedrige Kosten. Dies bietet zum einen den großen Vorteil, dass für den erfindungsgemäßen Kühler auf eine bereits bewährte Technologie der Massenfertigung in neuer Anwendung zurückgegriffen werden kann, und zum anderen, dass Prozessschritte leicht kombiniert und integriert werden können. So kann der Kühler beispielsweise zur Sicherstellung einer kräfteminimierten Montage ohne zusätzliche Halteklammer direkt auf die CPU vorzugsweise durch Löten oder Kleben montiert werden.

Zum Fügen der Bauteile müssen die Schichtdicke des Lotsystems und die Prozessparameter genau aufeinander abgestimmt sein, um auch ein Löten in den Laminierpressen zu ermöglichen. Bezüglich der möglichen Fügeverfahren wird auf DE 197 08 472 A1 hingewiesen.

Zur nachfolgenden Erläuterung der Erfindung wird auf die Figuren verwiesen. Es zeigen im einzelnen:
- **Fig. 1:**: eine schematische Darstellung einer strukturierten Metallfolie im Querschnitt,
- **Fig. 2:**: eine schematische Darstellung eines Mikrostrukturkühlers mit einem thermisch kontaktierten elektronischen Bauelement im Querschnitt,
- **Fig. 3:**: eine schematische Darstellung einer Mikrostrukturkühlerebene in einer ersten Designvariante A,
- **Fig. 4:**: eine schematische Darstellung einer Mikrostrukturkühlerebene in einer zweiten Designvariante B,
- **Fig. 5a:**: eine schematische Darstellung eines Mikrostrukturkühlers in einer ersten Designvariante A mit eingepressten Kühlmittelanschlüssen,
- **Fig. 5b:**: eine schematische Darstellung eines Mikrostrukturkühlers in einer ersten Designvariante A mit abgesetzten Verteilerräumen mit eingepressten Kühlmittelanschlüssen,
- **Fig**. **5c:**: eine schematische Darstellung eines Mikrostrukturkühlers in einer ersten Designvariante A mit eingeschraubten Kühlmittelanschlüssen,
- **Fig. 5d:**: eine schematische Darstellung eines Mikrostrukturkühlers in einer ersten Designvariante A mit eingeschraubten, abgewinkelten Kühlmittelanschlüssen,
- **Fig. 5e:**: eine schematische Darstellung eines Mikrostrukturkühlers in einer ersten Designvariante A mit abgesetzten Verteilerräumen, mit einer in Form eines Deckels geformten Deckplatte, mit eingeschraubten Kühlmittelanschlüssen und mit einer Kühlkanäle aufweisenden Grundplatte,
- **Fig. 6**:: eine schematische Darstellung eines Mikrostrukturkühlers in einer zweiten Designvariante B mit Kühlmittelanschlüssen.

Gleiche Bezugsziffern haben in allen Figuren dieselbe Bedeutung. Insoweit wird auch auf die anliegende Bezugszeichenliste verwiesen.

In **Fig. 1** sind einzelne Optimierungsparameter an einer Metallfolie **1** gezeigt, die zu einer Minimierung des Druckverlustes im Kühler sowie zur Minimierung der Temperaturdifferenz zwischen thermischer Kontaktfläche und in den Kühler einfließendem Kühlmittel oder zur Maximierung der Kühlleistung führen. Die Kanäle sind in der noch nicht gelöteten Metallfolie **1** als Ausnehmungen **2** gezeigt.

Es handelt sich dabei um die Kanalbreite **b**, die Kanaltiefe **t**, den Kanalabstand (die Stegbreite) **s** und die Restfoliendicke **r**. Außerdem ist die Breite **f** des strukturierten Bereichs auf der Metallfolie **1** angegeben. Der weitere Optimierungsparameter **g** (Grundplattendicke) ist in **Fig. 2** gezeigt.

In **Fig. 2** ist ein Kühler **3** mit thermisch kontaktiertem CPU-Prozessor **4** gezeigt. Der Kühler **3** besteht in diesem Falle aus vier Metallfolien **1,** die jeweils vier Kühlkanäle **2** und dazwischen liegende Stege **9** aufweisen. Die Kanäle **2** jeder Metallfolie **1** sind durch eine benachbarte Metallfolie **1** verschlossen. Zum CPU-Prozessor **4** hin sind die Kühlkanäle **2** der untersten Metallfolie **1** durch eine Grundplatte **5** verschlossen. Die Grundplatte **5** dient auch gleichzeitig dazu, die vom CPU-Prozessor **4** entwickelte Wärme über eine thermische Kontaktfläche 6 aufzunehmen. Hierzu ist der CPU-Prozessor **4** über ein Fügemittel mit guter thermischer Leitfähigkeit (z. B. Wärmeleitpaste, Lot, Leitkleber) **7** an die Grundplatte **5** im Bereich der thermischen Kontaktfläche **6** kontaktiert. Der CPU-Prozessor **4** ist auf eine CPU-Trägerplatte **8** montiert. Der Stapel aus Metallfolien **1** und Grundplatte **5** wird durch eine oben liegende Deckplatte **9** abgeschlossen. Die Grundplattendicke **g** ist ebenfalls gezeigt.

Nachfolgend werden unterschiedliche erfindungsgemäße Designs der Kanalführung in den Mikrostrukturkühlern dargestellt:

### Design A:

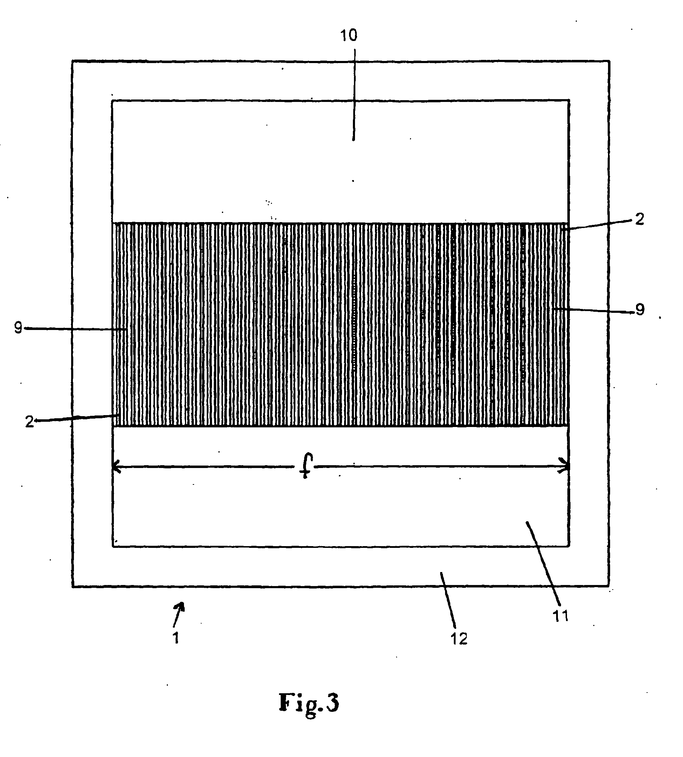

In **Fig. 3** ist ein Querschnitt durch einen Mikrostrukturkühler in der Höhe einer Metallfolie **1** schematisch gezeigt. In der Metallfolie **1** sind die einzelnen Kanäle **2** gezeigt. Die Kanäle **2** sind parallel zueinander angeordnet. Durch die parallele Anordnung wird eine Wärmeaustauschfläche beschrieben, die durch die Breite f und die Kanallänge gegeben ist und die größer ist als die thermisch kontaktierte Fläche des elektronischen Bauelements. Dies wird durch Wahl einer ausreichend großen Länge der Kanäle **2** erreicht. Die Kanäle **2** öffnen sich gegenüber einem Einlassverteilerraum **10** und einem Auslassverteilerraum **11**. Während sich die Kanäle **2** nur jeweils in der Ebene einer Metallfolie **1** befinden, erstrecken sich der Einlassverteilerraum **10** und der Auslassverteilerraum **11** über die gesamte innere Höhe des Kühlers, so dass die Kanäle **2** aller Metallfolien **1** im Kühler mit den beiden Verteilerräumen **10,11** verbunden sind.

Mehrere derartige Metallfolien **1** werden sowohl über die Stege **9** der strukturierten Folien **1** als auch über den Rand **12** der Folie **1** miteinander verlötet. Außerdem wird eine dieser Folien **1** über die Stege **9** und den Rand **12** mit einer Grundplatte verlötet. Die Länge der Kanäle **2** liegt beispielsweise bei etwa 20 mm, wenn die Grundfläche eines zu kühlenden CPU-Prozessors 10 mm x 10 mm beträgt. Durch einen Überstand der Kanäle **2** über die thermische Kontaktfläche für den CPU-Prozessor von 5 mm an jeder Seite ergibt sich somit eine Kanallänge von 20 mm und eine Breite **f** der von Kanälen **2** überstrichenen Wärmeaustauschfläche von ebenfalls 20 mm.

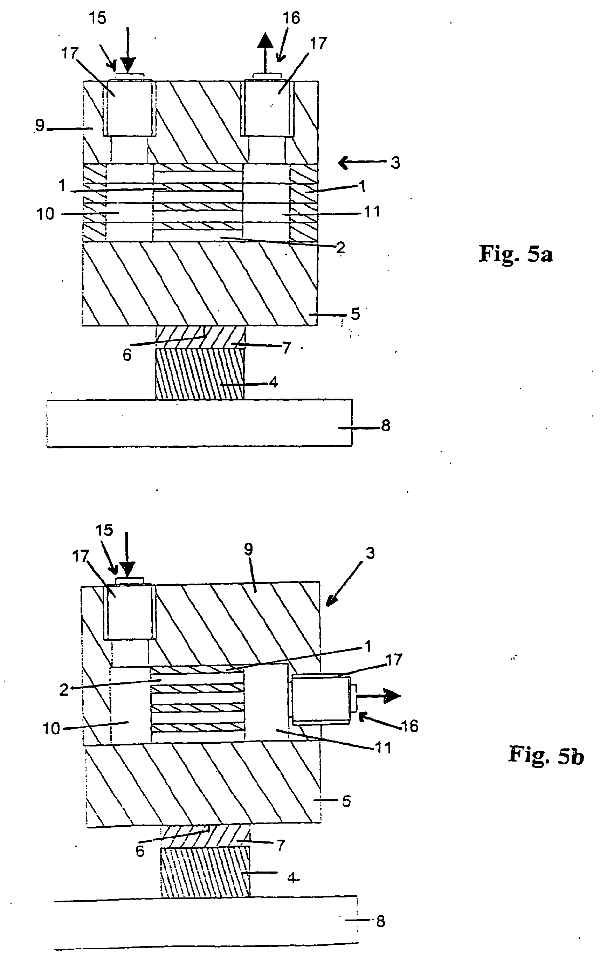

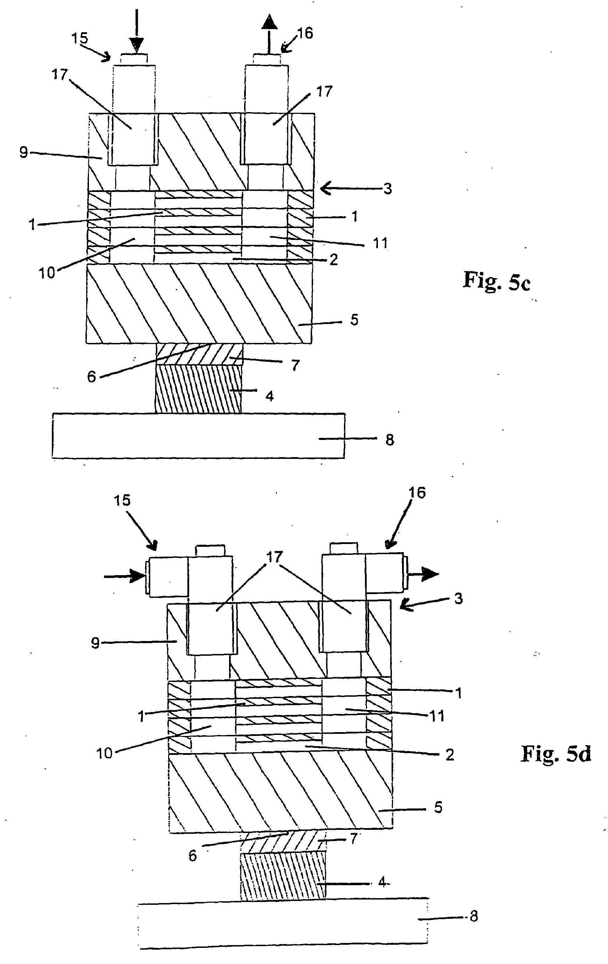

In **Fig. 5a** ist ein Mikrostrukturkühler **3** im Querschnitt dargestellt, wobei in diesem Fall die Anschlüsse für Kühlmittel, das in den Kühler **3** hinein- und aus diesem wieder herausgeleitet wird, gezeigt sind. Es handelt sich hierbei um eine Einlassbuchse **15** sowie eine Auslassbuchse **16.** Zur schnellen und kostengünstigen Montage sind Schnellsteckverbinder **17** in die Buchsen **15** und **16** eingepresst oder eingeschraubt. Dadurch kann ein Schlauch, beispielsweise mit einem Durchmesser von 4 oder 8 mm, angeschlossen werden.

In **Fig. 5b** ist ein weiterer Mikrostrukturkühler **3** im Querschnitt dargestellt. In diesem Fall ist die Anschlussbuchse **15** und der in diese Buchse eingepresste Schnellsteckverbinder **17** oben im Bereich der Deckplatte **9** eingelassen. Die andere Anschlussbuchse **16** mit eingepresstem Schnellsteckverbinder **17** ist seitlich in die über den Kanalbereich ragende Deckplatte **9** eingelassen.

In diesem Falle werden Metallfolien **1** mit Kühlkanälen **2** verwendet, die keine Verteilerräume **10,11** umfassen. Vielmehr weisen die Metallfolien **1** ausschließlich parallel zueinander angeordnete Kühlmittelkanäle **2** auf. Durch Fügen mehrerer Metallfolien **1** mit Kanälen **2** zu einem Kühlblock öffnen sich die Kühlkanäle an den Stirnseiten des Kühlblocks. Dieser Kühlblock wird zusammen mit der Grundplatte **5** und der Deckplatte **9** so zusammengebaut, dass sich Hohlräume bilden, die an die Stirnseiten des Kühlblocks angrenzen und in die sich die Kanäle **2** öffnen. Diese Hohlräume bilden den Einlassverteilerraum **10** und den Auslassverteilerraum **11**. Die Anschlussbuchsen **15,16** mit den Schnellsteckverbindem münden unmittelbar in die Verteilerräume 10,11. Die Deckplatte **9** kann kostengünstig als Spritzgussteil aus Kunststoff hergestellt werden. Dadurch dass der Kühlblock im wesentlichen auf die Größe der CPU **4** verringert ist; können die Herstellkosten für den Kühler **3** deutlich gesenkt werden.

Eine weitere Kühlervariante ist in **Fig. 5c** wiedergegeben. In diesem Falle sind die Schnellsteckverbinder **17** für die Einlassbuchse **15** und für die Auslassbuchse **16** im Gegensatz zu der in **Fig. 5a** gezeigten Variante als einschraubbare Verbinder ausgeführt. Im übrigen entspricht diese Ausführungsform der von **Fig. 5a.**

Noch eine weitere Kühlervariante ist in **Fig. 5d** dargestellt. In diesem Falle sind die Schnellsteckverbinder **17** für die Einlassbuchse **15** und für die Auslassbuchse **16** im Gegensatz zu der in **Fig. 5c** gezeigten Ausführungsform in abgewinkelter Form ausgeführt. Dadurch wird eine alternative Montage der Schlauchanschlüsse von der Seite möglich, so dass eine geringere Bauhöhe erreicht werden kann. Weitere Vorteile bestehen auch darin, dass die Schläuche kräftefrei angeschlossen werden können und dass sie auch unter beengten Platzverhältnissen leicht montierbar sind. Im übrigen entspricht diese Ausführungsform der von **Fig. 5c.**

In einer weiteren Ausführungsform des erfindungsgemäßen Kühlers **3** ist die Deckplatte **9** gemäß **Fig. 5e** in Form eines Deckels beispielsweise aus Kunststoff ausgeführt. Dieser Deckel **9** kann vorzugsweise durch Spritzgießen hergestellt werden. Der Deckel umschließt den Bereich der durch die Kühlkanäle **2** in den Metallfolien **1** gebildeten Kühlblock. In dem Deckel **9** sind auch die Einlassbuchse **15** und die Auslassbuchse **16** integriert, die einpressbare Schnellsteckverbinder **17** aufnehmen.

Der aus den mit Kühlkanälen **2** versehenen Metallfolien **1** bestehende Kühlblock weist etwa die Größe der CPU **4** auf. Die Kühlkanäle **2** in den Metallfolien **1** öffnen sich in den Einlassverteilerraum **10** und den Auslassverteilerraum **11.** Die Verteilerräume **10,11** stehen unmittelbar mit der Einlassbuchse **15** bzw. der Auslassbuchse **16** in Verbindung.

Die unterste Metallfolie **1** des Kühlblocks ist gleichzeitig die Grundplatte. In diesem Falle erfüllt die Grundplattendicke **g** die erfindungsgemäßen Bedingungen, d.h. die Grundplattendicke **g** liegt im Bereich von 200 - 2.000 µm. Dagegen ist die Restfoliendicke **r** für diese unterste Metallfolie **1,** in der sich auch Kühlkanäle **2** befinden, nicht notwendigerweise innerhalb des erfindungsgemäßen Bereichs von 50 - 300 µm einzustellen. Allerdings liegt die Restfoliendicke **r** für die übrigen Metallfolien **1** innerhalb des erfindungsgemäßen Bereichs von 50 - 300 µm.

Die CPU **4** ist wiederum auf einer Trägerplatte **8** montiert und steht mit dem Kühler **3** über eine thermische Kontaktfläche **6** in Kontakt. Die CPU **4** ist auf der Trägerplatte **8** in eine Aussparung in eine elektrische Isolierschicht **18,** beispielsweise einen Schutzlack, eingesetzt und wird von diesem umgeben, so dass der Kühler **3** die CPU **4** nach außen hermetisch abschließt.

### Design B:

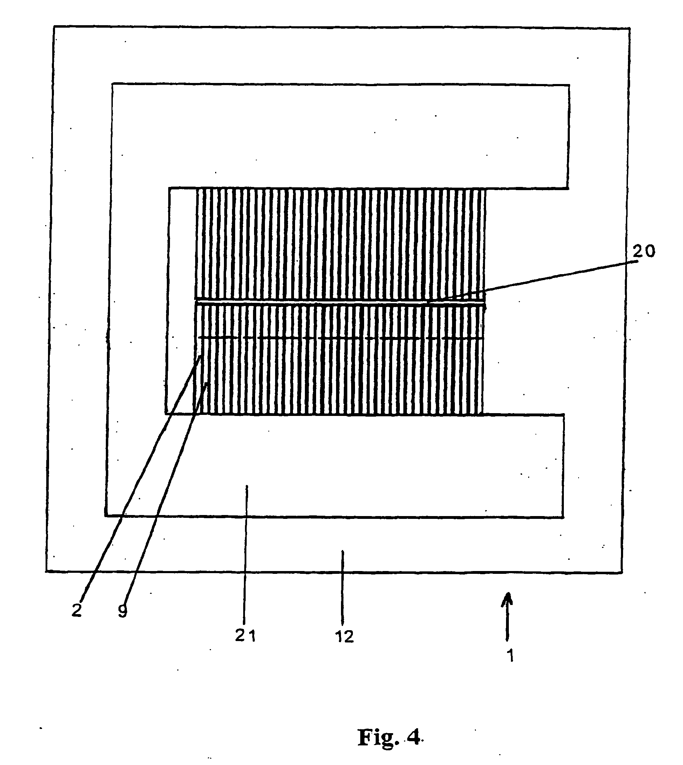

Um den Druckverlust innerhalb der mikrostrukturierten Kanäle **2** und damit die notwendige Durchflussmenge des Kühlmediums im Hinblick auf eine Verkleinerung und Optimierung des Kühlers und des gesamten Kühlsystems, einschließlich einer Kühlmittelpumpe und der Flüssigkeitsschläuche, zu minimieren, sind die Metallfolien **1** etwa in der Höhe der thermischen Kontaktfläche durch mindestens eine Verteilerkammer **20** unterbrochen ("splitted channel design"). In **Fig. 4** ist diese Verteilerkammer **20** in einer Mikrostrukturkühlerebene als Spalt dargestellt, die die Kanäle **2** und die Stege **9** anschneidet. Während die Kanäle **2** nur teilweise aus der in **Fig. 4** gezeigten Metallfolie **1** ausgenommen ist, stellt der Spalt **20** einen die Metallfolie **1** vollständig durchbrechenden Schlitz dar. Beim Übereinanderlegen mehrerer derartiger Metallfolien **1** werden somit Kanäle **2** zur Aufnahme des Kühlmittels gebildet, die innerhalb der Metallfolienebene verlaufen. Die durch den Spalt gebildete Verteilerkammer **20** erstreckt sich dagegen über das gesamte Innere des Kühlers.

In **Fig. 4** ist weiterhin dargestellt, dass sich die Kanäle **2** in eine Sammelkammer **21** öffnen. Die Sammelkammer **21** umschließt die Kanalfläche an drei Seiten, so dass Kühlmittel von der Verteilerkammer **20** in die oberen Kanäle **2** und die unteren Kanäle **2** in der Figur eintreten kann. Das aus den Kanälen **2** wieder austretende Kühlmittel gelangt in die U-förmige Sammelkammer **21.** Durch diese Kühlmittelführung wird eine hervorragende Kühlleistung ermöglicht. Bei umgekehrter Kühlmittelführung, d.h. bei Einleiten des Kühlmittels von der Sammelkammer **21** in die Kanäle **2,** von wo aus das Kühlmittel in die Verteilerkammer **20** gelangt, wird eine wesentlich schlechtere Kühlleistung erreicht.

Die Sammelkammer **21** ist ebenso wie die Verteilerkammer **20** in der Metallfolie **1** als durchgehende Ausnehmung gebildet, so dass sich diese Kammer **21** nach dem Übereinanderlegen mehrerer derartiger Folien **1** über die gesamte innere Höhe des Kühlers erstreckt. Dadurch wird ebenso wie bei der Verteilerkammer **20** erreicht, dass das Kühlmittel gleichmäßig über alle Kanäle **2** verteilt wird.

Zur Ableitung von Kühlmittel aus dem Kühler können zwei Anschlussstutzen vorgesehen sein, über die das Kühlmittel aus den Verteilerkammern **20** abgeführt wird. Nach Durchtritt des Kühlmittels durch die Kanäle **2** gelangt es in die beiden Schenkel der Sammelkammer **21** und wird von dort wieder aus dem Kühler herausgeführt.

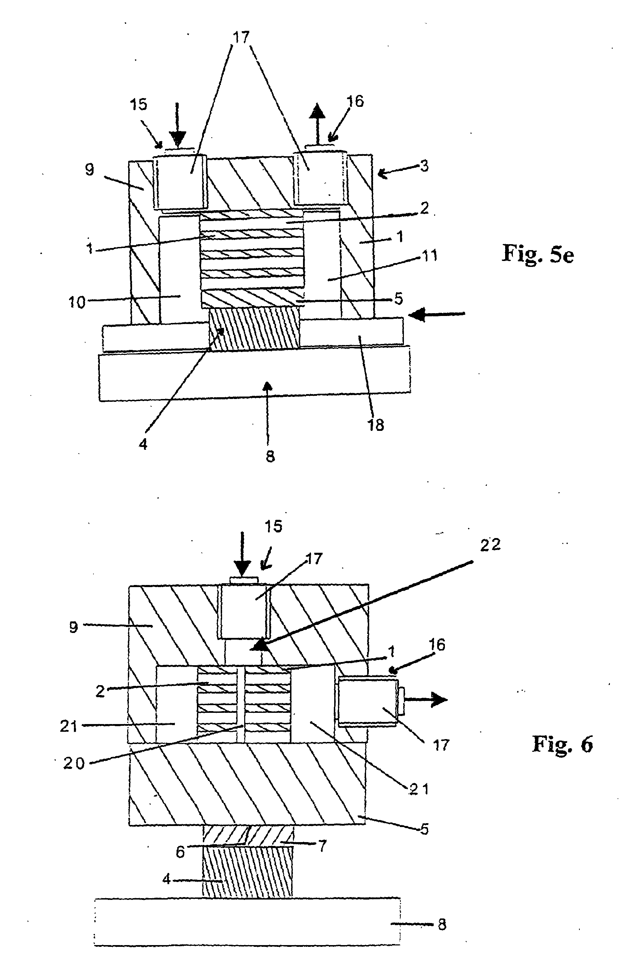

In **Fig. 6** ist eine schematische Darstellung eines Mikrostrukturkühlers **3** im Querschnitt mit Kühlmittelanschlüssen dargestellt. Auch in diesem Falle haben die Bezugszeichen die bereits zuvor angegebenen Bedeutungen.

In diesem Fall ist wie in **Fig. 5b** ein Aufbau des Kühlers **3** mit einem Kühlblock aus Metallfolien **1** und darin angeordneten Kühlkanälen **2** gezeigt. Der Kühlblock weist wiederum etwa dieselbe Größe auf wie die thermische Kontaktfläche der CPU **4**. Durch die den Kanalbereich im Kühlblock überkragende Deckplatte **9**, die vorzugsweise als Spritzgussteil aus Kunststoff hergestellt sein kann, entstehen zwei Kammern, die Sammelkammern **21** bilden. Diese Kammern **21** sind miteinander verbunden: Ferner sind die Metallfolien entsprechend der Anordnung in **Fig. 4** mittig unterbrochen und bilden so eine Verteilerkammer **20**, die die Kühlkanäle **2** anschneidet.

In der Deckplatte **9** sind zwei Anschlussbuchsen **15** und **16** eingelassen, die Schnellsteckverbinder **17** aufnehmen. Der Schnellsteckverbinder **17** in der Anschlussbuchse **15** dient zur Einleitung von Kühlmittel in den Kühler **3** und der Schnellsteckverbinder **16** zur Ableitung von Kühlmittel aus dem Kühler **3**. An die Schnellsteckverbinder **17** können wiederum Schläuche angeschlossen werden. Die Anschlussbuchse **15** mündet in einen Verteilerkanal **22**, der wiederum in die Verteilerkammer **20** mündet.

### Bezugszeichenliste:

- **1**: Metallfolie
- **2**: Kanal
- **3**: Mikrostrukturkühler
- **4**: CPU-Prozessor
- **5**: Grundplatte
- **6**: thermische Kontaktfläche
- **7**: thermischer Leitkleber
- **8**: CPU-Trägerplatte
- **9**: Deckplatte
- **10**: Einlassverteilerraum
- **11**: Auslassverteilerraum
- **12**: Rand der Metallfolie 1
- **15**: Einlassbuchsen
- **16**: Auslassbuchse
- **17**: Schnellsteckverbinder
- **20**: Verteilerkammer
- **21**: Sammelkammer
- **22**: Verteilerkanal
- **b**: Kanalbreite
- **t**: Kanaltiefe
- **s**: Kanalabstand (Stegbreite)
- **r**: Restfoliendicke
- **f**: Breite des strukturierten Bereichs auf der Metallfolie 1
- **g**: Grundplattendicke

## Patentansprüche

1. Mikrostrukturkühler (**3**) für einen zu kühlenden Gegenstand (**4**), wobei der Kühler (**3**) einen Stapel von mindestens zwei Metallfolien (**1**) und einer über eine thermische Kontaktfläche (**6**) in thermischen Kontakt mit dem Gegenstand (**4**) bringbaren Grundplatte (**5**) umfasst, die Metallfolien (**1**) und die Grundplatte (**5**) stoffschlüssig miteinander verbunden sind, in den Metallfolien (**1**) Kanäle (**2**) für Kühlmittel vorhanden sind und die Kanäle (**2**) eine Breite **b** im Bereich von 100 bis 2.000 µm, eine Tiefe **t** im Bereich von 25 bis 1.000 µm und einen mittleren Abstand **s** im Bereich von 50 bis 1.000 µm haben, durch die Kanäle (**2**) in den Metallfolien (**1**) entstehende Restfoliendicken **r** im Bereich von 50 bis 300 µm liegen und die Grundplatte (**5**) eine Dicke **g** im Bereich von 200 bis 2.000 µm aufweist.

2. Mikrostrukturkühler nach Anspruch 1, **dadurch gekennzeichnet, dass** das Verhältnis der Kanalbreite **b** zum mittleren Abstand s der Kanäle im Bereich von 1,5 : 1 bis 2,5 : 1 liegt.

3. Mikrostrukturkühler nach einem der vorstehenden Ansprüche, **dadurch gekennzeichnet, dass** das Verhältnis der Kanalbreite **b** zur Restfoliendicke r im Bereich von 2 : 1 bis 5 : 1 liegt.

4. Mikrostrukturkühler nach einem der vorstehenden Ansprüche, **dadurch gekennzeichnet, dass** die Breite **b** der Kanäle im Bereich von 200 bis 500 µm liegt.

5. Mikrostrukturkühler nach einem der vorstehenden Ansprüche, **dadurch gekennzeichnet, dass** die Tiefe **t** der Kanäle im Bereich von 50 bis 400 µm liegt.

6. Mikrostrukturkühler nach einem der vorstehenden Ansprüche, **dadurch gekennzeichnet, dass** der mittlere Abstand **s** der Kanäle im Bereich von 150 bis 300 µm liegt.

7. Mikrostrukturkühler nach einem der vorstehenden Ansprüche, **dadurch gekennzeichnet, dass** die Restfoliendicke **r** im Bereich von 80 bis 120 µm liegt.

8. Mikrostrukturkühler nach einem der vorstehenden Ansprüche, **dadurch gekennzeichnet, dass** die Dicke **g** der Grundplatte im Bereich von 500 bis 1.500 µm liegt.

9. Mikrostrukturkühler nach einem der vorstehenden Ansprüche, **dadurch gekennzeichnet, dass** eine durch die Kanäle (**2**) beschriebene Wärmeaustauschfläche größer ist als die thermische Kontaktfläche (**6**).

10. Mikrostrukturkühler nach einem der vorstehenden Ansprüche, **dadurch gekennzeichnet, dass** die Kanäle (**2**) in den Metallfolien (**1**) im wesentlichen parallel zueinander verlaufen.

11. Mikrostrukturkühler nach einem der vorstehenden Ansprüche, **dadurch gekennzeichnet, dass** mindestens ein Einlassverteilerraum (**10**) und mindestens ein Auslassverteilerraum (**11**) für das Kühlmittel vorgesehen sind.

12. Mikrostrukturkühler nach Anspruch 11, **dadurch gekennzeichnet, dass** alle Kanäle (**2**) einlassseitig mit dem Einlassverteilerraum (**10**) und auslassseitig mit dem Auslassverteilerraum (**11**) verbunden sind.

13. Mikrostrukturkühler nach einem der Ansprüche 11 und 12, **dadurch gekennzeichnet, dass** mindestens ein erster Anschlussstutzen vorgesehen ist, der mit dem mindestens einen Einlassverteilerraum (**10**) verbunden ist und dass mindestens ein zweiter Anschlussstutzen vorgesehen ist, der mit dem mindestens einen Auslassverteilerraum (**11**) verbunden ist.

14. Mikrostrukturkühler nach einem der Ansprüche 1 bis 10, **dadurch gekennzeichnet, dass** die Metallfolien (**1**) etwa in der Höhe der thermischen Kontaktfläche (**6**) durch mindestens eine Verteilerkammer (**20**) unterbrochen sind, dass alle Kanäle (**2**) an deren einem Ende mit der mindestens einen Verteilerkammer (**20**) verbunden sind und dass ferner mindestens eine Sammelkammer (**21**) innerhalb des Kühlers (**3**) vorgesehen ist, mit der alle Kanäle (**2**) an deren anderem Ende verbunden sind.

15. Mikrostrukturkühler nach Anspruch 14, **dadurch gekennzeichnet, dass** zwei Gruppen von im wesentlichen parallel zueinander verlaufenden Kanälen (**2**) vorgesehen sind und dass die mindestens eine Verteilerkammer (**20**) als Spalt zwischen den beiden Gruppen ausgebildet ist.

16. Mikrostrukturkühler nach Anspruch 15, **dadurch gekennzeichnet, dass** die Breite des Spaltes (**20**) im Bereich von 50 bis 2.000 µm liegt.

17. Mikrostrukturkühler nach einem der Ansprüche 14 bis 16, **dadurch gekennzeichnet, dass** mindestens ein erster Anschlussstutzen vorgesehen ist, der mit der mindestens einen Verteilerkammer (**20**) verbunden ist und dass mindestens ein zweiter Anschlussstutzen vorgesehen ist, der mit der mindestens einen Sammelkammer (**21**) verbunden ist.

18. Verwendung des Mikrostrukturkühlers nach einem der Ansprüche 1 bis 17 zur Kühlung elektronischer Bauelemente.

## Claims

1. Microstructure cooler (3) for an object (4) to be cooled, the cooler (3) comprising a stack of at least two metals foils (1) and a base plate (5) which can be brought into thermal contact with the object (4) via a thermal contact face (6), the metal foils (1) and the base plate (5) being connected to each other integrally, channels (2) for coolant being present in the metal foils (1), and the channels (2) having a width b in the range of 100 to 2,000 µm, a depth t in the range of 25 to 1,000 µm and an average spacing s in the range of 50 to 1,000 µm, residual foil thicknesses r, which occur due to the channels (2) in the metal foils (1), being in the range of 50 to 300 µm and the base plate (5) having a thickness g in the range of 200 to 2,000 µm.

2. Microstructure cooler according to claim 1, **characterised in that** the ratio of the channel width b to the average spacing s of the channels is in the range of 1.5 : 1 to 2.5 : 1.

3. Microstructure cooler according to one of the preceding claims, **characterised in that** the ratio of the channel width b to the residual foil thickness r is in the range of 2 : 1 to 5 : 1.

4. Microstructure cooler according to one of the preceding claims, **characterised in that** the width b of the channels is in the range of 200 to 500 µm.

5. Microstructure cooler according to one of the preceding claims, **characterised in that** the depth t of the channels is in the range of 50 to 400 µm.

6. Microstructure cooler according to one of the preceding claims, **characterised in that** the average spacing s of the channels is in the range of 150 to 300 µm.

7. Microstructure cooler according to one of the preceding claims, **characterised in that** the residual foil thickness r is in the range of 80 to 120 µm.

8. Microstructure cooler according to one of the preceding claims, **characterised in that** the thickness g of the base plate is in the range of 500 to 1,500 µm.

9. Microstructure cooler according to one of the preceding claims, **characterised in that** a heat exchange face described by the channels (2) is larger than the thermal contact face (6).

10. Microstructure cooler according to one of the preceding claims, **characterised in that** the channels (2) in the metal foils (1) extend substantially parallel to each other.

11. Microstructure cooler according to one of the preceding claims, **characterised in that** at least one inlet distribution chamber (10) and at least one outlet distribution chamber (11) are provided for the coolant.

12. Microstructure cooler according to claim 11, **characterised in that** all the channels (2) are connected, on the inlet side, to the inlet distribution chamber (10) and, on the outlet side, to the outlet distribution chamber (11).

13. Microstructure cooler according to one of the claims 11 and 12, **characterised in that** at least one first connection pipe is provided which is connected to the at least one inlet distribution chamber (10), and **in that** at least one second connection pipe is provided which is connected to the at least one outlet distribution chamber (11).

14. Microstructure cooler according to one of the claims 1 to 10, **characterised in that** the metal foils (1) are interrupted approximately at the level of the thermal contact face (6) by at least one distribution chamber (20), **in that** all the channels (2) are connected at one end thereof to the at least one distribution chamber (20) and **in that**, in addition, at least one collection chamber (21) is provided within the cooler (3), to which all the channels (2) are connected at the other end thereof.

15. Microstructure cooler according to claim 14, **characterised in that** two groups of channels (2) which extend substantially parallel to each other are provided, and **in that** the at least one distribution chamber (20) is configured as a gap between the two groups.

16. Microstructure cooler according to claim 15, **characterised in that** the width of the gap (20) is in the range of 50 to 2,000 µm.

17. Microstructure cooler according to one of the claims 14 to 16, **characterised in that** at least one first connection pipe is provided which is connected to the at least one distribution chamber (20), and **in that** at least one second connection pipe is provided which is connected to the at least one collection chamber (21).

18. Use of the microstructure cooler according to one of the claims 1 to 17 for cooling electronic components.

## Revendications

1. Dissipateur de chaleur à microstructures (3) pour un objet à refroidir (4), dans lequel le dissipateur (3) comprend un empilage d'au moins deux feuilles de métal (1) et d'une plaque de base (5) qui peut être mis en contact thermique avec l'objet (4) par le biais d'une surface de contact thermique (6), les feuilles de métal (1) et la plaque de base (5) sont reliées les unes aux autres par fusion de matière, des canaux (2) sont prévus dans les feuilles de métal (1) pour un agent réfrigérant et les canaux (2) ont une largeur b dans la plage de 100 à 2 000 µm, une profondeur t dans la plage de 25 à 1 000 µm et un entraxe moyen s dans la plage de 50 à 1 000 µm, les épaisseurs de feuilles résiduelles r laissées par les canaux (2) dans les feuilles de métal (1) se situent dans la plage de 50 à 300 µm et la plaque de base (5) présente une épaisseur g dans la plage de 200 à 2 000 µm.

2. Dissipateur de chaleur à microstructures selon la revendication 1, **caractérisé en ce que** le rapport de la largeur de canal b sur l'entraxe moyen s des canaux se situe dans la plage de 1,5 : 1 à 2,5 : 1.

3. Dissipateur de chaleur à microstructures selon l'une des revendications précédentes, **caractérisé en ce que** le rapport de la largeur de canal b sur l'épaisseur de feuille résiduelle r se situe dans la plage de 2 : 1 à 5 : 1.

4. Dissipateur de chaleur à microstructures selon l'une des revendications précédentes, **caractérisé en ce que** la largeur b des canaux se situe dans la plage de 200 à 500 µm.

5. Dissipateur de chaleur à microstructures selon l'une des revendications précédentes, **caractérisé en ce que** la profondeur t des canaux se situe dans la plage de 50 à 400 µm.

6. Dissipateur de chaleur à microstructures selon l'une des revendications précédentes, **caractérisé en ce que** l'entraxe moyen s des canaux se situe dans la plage de 150 à 300 µm.

7. Dissipateur de chaleur à microstructures selon l'une des revendications précédentes, **caractérisé en ce que** l'épaisseur de feuille résiduelle r se situe dans la plage de 80 à 120 µm.

8. Dissipateur de chaleur à microstructures selon l'une des revendications précédentes, **caractérisé en ce que** l'épaisseur g de la plaque de base se situe dans la plage de 500 à 1 500 µm.

9. Dissipateur de chaleur à microstructures selon l'une des revendications précédentes, **caractérisé en ce qu'**une surface d'échange thermique décrite par les canaux (2) est plus grande que la surface de contact thermique (6).

10. Dissipateur de chaleur à microstructures selon l'une des revendications précédentes, **caractérisé en ce que** les canaux (2) s'étendent sensiblement parallèlement les uns aux autres dans les feuilles de métal (1).

11. Dissipateur de chaleur à microstructures selon l'une des revendications précédentes, **caractérisé en ce qu'**il est prévu au moins un espace de distribution d'entrée (10) et au moins un espace de distribution de sortie (11) pour l'agent réfrigérant.

12. Dissipateur de chaleur à microstructures selon la revendication 11, **caractérisé en ce que** tous les canaux (2) sont reliés côté entrée à l'espace de distribution d'entrée (10) et côté sortie à l'espace de distribution de sortie (11).

13. Dissipateur de chaleur à microstructures selon l'une des revendications 11 et 12, **caractérisé en ce qu'**il est prévu au moins un premier raccord qui est relié audit au moins un espace de distribution d'entrée (10) et **en ce qu'**il est prévu au moins un deuxième raccord qui est relié audit au moins un espace de distribution de sortie (11).

14. Dissipateur de chaleur à microstructures selon l'une des revendications 1 à 10, **caractérisé en ce que** les feuilles de métal (1) sont interrompues à peu près à la hauteur de la surface de contact thermique (6) par au moins une chambre de distribution (20), **en ce que** tous les canaux (2) sont reliés à l'une de leurs extrémités à ladite au moins une chambre de distribution (20), et **en ce qu'**il est prévu en outre à l'intérieur du dissipateur (3) au moins une chambre collectrice (21) à laquelle tous les canaux (2) sont reliés à leur autre extrémité.

15. Dissipateur de chaleur à microstructures selon la revendication 14, **caractérisé en ce qu'**il est prévu deux groupes de canaux (2) qui s'étendent sensiblement parallèlement les uns aux autres et **en ce que** ladite au moins une chambre de distribution (20) est réalisée sous la forme d'une fente entre les deux groupes.

16. Dissipateur de chaleur à microstructures selon la revendication 15, **caractérisé en ce que** la largeur de la fente (20) se situe dans la plage de 50 à 2 000 µm.

17. Dissipateur de chaleur à microstructures selon l'une des revendications 14 à 16, **caractérisé en ce qu'**il est prévu au moins un premier raccord qui est relié à ladite au moins une chambre de distribution (20) et **en ce qu'**il est prévu au moins un deuxième raccord qui est relié à ladite au moins une chambre collectrice (21).

18. Utilisation du dissipateur de chaleur à microstructures selon l'une des revendications 1 à 17 pour refroidir des composants électroniques.
